# EUROPEAN PATENT APPLICATION

(11) **EP 4 848 589 A1**
(43) Date of publication of application: **02.12.2026**
(21) Application number: 26179915.9
(22) Date of filing: 20.05.2026
(51) Int. Cl.: H03K 17/0812, G11C 27/02, H03K 17/10, H03M 1/12

(54) **AUTOBOOT STRAP SWITCH CAPABLE OF 2X VDD INPUT VOLTAGE AND SUPPORT FOR CURRENT INJECTION**

(30) Priority: 27.05.2025 IN 202541050758
(71) Applicant: NXP USA, Inc, Austin, TX 78735 (US)
(72) Inventor: Rawat, Sreyansh, 5656AG Eindhoven (NL); Kumar, Atul, 5656AG Eindhoven (NL); Mai, Khoi, 5656AG Eindhoven (NL); Berens, Michael Todd, 5656AG Eindhoven (NL); Thakur, Akshay, 5656AG Eindhoven (NL)
(74) Representative: Schwarzweller, Thomas

(57) **Abstract**

A voltage switch for handling over-voltages includes an input terminal for receiving an input voltage that may exceed a voltage rating for at least some transistors in the voltage switch, a current injection detector, a capacitor, pre-charging circuitry for pre-charging the first capacitor, a boost select circuit for generating a boosted voltage from the capacitor, an output switch circuit including an four cascoded FinFET devices which are source-drain connected between the input terminal and an output terminal, and control switches configured to selectively connect, in response to a sampling control signal, a ground supply voltage, intermediate supply voltage, and elevated supply voltage as gate bias voltages to the control electrodes of the plurality of FinFET devices in response to any detected positive current injection event or negative current injection event, thereby preventing overvoltage stress of the first FinFET device.

## Description

### BACKGROUND OF THE INVENTION

### Field of the Invention

The present disclosure is directed in general to electrical circuitry. In one aspect, the present disclosure relates generally to voltage sampling switch circuitry.

### Description of the Related Art

The field of integrated circuit (IC) technology is currently undergoing a significant shift towards advanced technology nodes, such as Fin Field-Effect Transistor (FinFET) nodes. This transition is driven by the inherent advantages of FinFETs over traditional planar transistors, particularly in advanced system-on-chip (SoC) designs. FinFET architectures offer superior gate control, which effectively mitigates short-channel effects prevalent in scaled planar devices. This enhanced control translates to the ability to operate at lower supply voltages while simultaneously achieving improved performance characteristics. Furthermore, FinFETs exhibit significantly reduced leakage currents, a critical factor in minimizing static power consumption in increasingly dense integrated circuits. With the introduction of FinFET devices, board level system developers are increasingly adopting system designs that integrate both cutting-edge FinFET-based ICs and legacy planar IC devices onto a single printed circuit board (PCB) to leverage the distinct benefits offered by each technology.

However, the integration of IC devices fabricated using different technology nodes on a common PCB introduces notable challenges, particularly concerning their respective operating voltage requirements. A fundamental issue arises from the disparity in optimal supply voltages between FinFET and planar devices. For instance, a Successive Approximation Register (SAR) Analog-to-Digital Converter (ADC) IC, designed utilizing FinFET transistor technology, may necessitate operation at lower supply voltages, such as 1.8V, to capitalize on the efficiency and performance benefits of FinFETs. This lower operating voltage can be incompatible with other integrated circuit devices present on the same PCB that are designed with planar transistors and require significantly higher supply voltages, such as 3.3V, for proper operation. This voltage incompatibility necessitates careful consideration in the system design to ensure reliable and efficient operation of all interconnected components.

A specific concern arising from these mixed-node systems relates to the potential for overvoltage conditions and powered current injection into the lower voltage FinFET devices from the higher voltage planar devices. In scenarios where a higher voltage signal is inadvertently applied to an input or output pin of a lower voltage FinFET IC, the device can be subjected to voltages exceeding its maximum operating limits. This overvoltage stress can lead to device degradation, performance issues, or even catastrophic failure. Moreover, if a higher voltage source is actively driving current into a pin of a lower voltage device, a phenomenon known as powered current injection, it can also cause improper functionality or damage to the sensitive FinFET circuitry. Protecting these advanced FinFET ICs from such potentially damaging voltage excursions and current injection events is crucial for the overall reliability and robustness of the mixed-node electronic system.

As seen from the foregoing, there are numerous technical challenges and difficulties with introducing advanced IC devices in system designs which use IC devices from older technology nodes, including but not limited to potential negative interactions between operating voltage ranges that can result in damaging input voltages and current injection events at the advanced IC devices. For the system manufacturers to gain advantages by replacing an IC with a lower cost advanced IC device manufactured at a more advanced process technology, a new system PCB design could be required to route the appropriate lower voltage to the lower cost IC. Design changes to the PCB would likely require a requalification of the system, impacting production and incurring significant costs. As such, there is a need for ICs to be processed in an advanced technology without impacting the supply voltage requirements of the ICs. Further limitations and disadvantages of conventional processes and technologies will become apparent to one of skill in the art after reviewing the remainder of the present application with reference to the drawings and detailed description which follow.

### BRIEF DESCRIPTION OF THE DRAWINGS

The present disclosure may be understood, and its numerous objects, features and advantages obtained, when the following detailed description of a preferred embodiment is considered in conjunction with the following drawings.
Figure 1 illustrates a simplified block diagram of a single-ended Successive Approximation Register (SAR) Analog-to-Digital Converter (ADC) with an input multiplexer in accordance with selected embodiments of the present disclosure.
Figure 2A illustrates a simplified circuit schematic of a bootstrap switch circuit.
Figure 2B illustrates a simplified circuit schematic of a track and hold bootstrap switch circuit.
Figure 2C illustrates a simplified circuit schematic of a pre-charge, track and hold bootstrap switch circuit.
Figure 3 illustrates a schematic circuit diagram of an input voltage sampling switch circuit wherein input over-voltages over twice the maximum voltage allowed on the transistors can cause stress to individual transistor devices from current injection events.
Figure 4 shows voltage timing signals seen by transistor devices in the input voltage sampling switch circuit during negative and positive current injection events.
Figure 5 is a simplified circuit schematic of an input voltage sampling switch circuit in accordance with selected embodiments of the present disclosure.
Figure 6 is a detailed circuit schematic of an input voltage sampling switch circuit in accordance with selected embodiments of the present disclosure.
Figure 7 is a simplified schematic block diagram of a current injection detector for detecting positive and negative current injection events in accordance with selected embodiments of the present disclosure.
Figure 8 is a simplified schematic block diagram of a control signal generator which generates switching control signals in response to the positive and negative current detection signals in accordance with selected embodiments of the present disclosure.
Figure 9 is a simplified circuit schematic of a control signal generator for generating the p_gate_1 control signal in accordance with selected embodiments of the present disclosure.
Figure 10 shows simulated voltage timing signals for voltage nodes seen by devices in the input voltage sampling switch circuit during positive injection in accordance with selected embodiments of the present disclosure.
Figure 11 shows simulated voltage timing signals for voltage nodes seen by devices in the input voltage sampling switch circuit during negative injection in accordance with selected embodiments of the present disclosure.
Figure 12 shows timing waveforms for inputs and outputs showing the tracking (sampling) operation.
Figure 13A shows a detailed circuit diagram of a first portion of the input voltage sampling switch circuit in accordance with selected embodiments of the present disclosure.
Figure 13B shows a detailed circuit diagram of a second portion of the input voltage sampling switch circuit in accordance with selected embodiments of the present disclosure.
Figure 13C shows a detailed circuit diagram of a third portion of the input voltage sampling switch circuit in accordance with selected embodiments of the present disclosure.

### DETAILED DESCRIPTION

A system, apparatus, and methodology are described for a bootstrap switch circuit designed to address the challenges of integrating FinFET IC devices, which operate at lower voltages, within systems that also include devices operating at higher voltages. The disclosed bootstrap switch circuit includes an injection detector circuit that is capable of detecting the presence or absence of current injection events, including positive and negative current injection events. The disclosed bootstrap switch circuit also includes a first boost capacitor, a first pre-charge circuit, a second pre-charge circuit, a boost transfer circuit, an output switch circuit, and a plurality of control switches positioned between the boost transfer circuit and the output switch circuit to control the bias voltages applied to transistor devices in the output switch circuit. In operation, the first pre-charge circuit is responsible for pre-charging the first capacitor to a first voltage in response to a first control signal, and the second pre-charge circuit pre-charges the first capacitor to a second voltage in response to a complementary second control signal. In addition, the boost transfer circuit is coupled to the first capacitor to facilitate efficient voltage transfer to a voltage boost node with first and second transistors which are connected and configured to boost the voltage boost node. The output switch circuit includes a plurality of cascoded n-type FinFET devices connected in a source-drain configuration between an input and output voltage terminal. To ensure safe and reliable operation, particularly in the presence of current injection, the plurality of control switches is selectively activated in response to control signals from the injection detector circuit to control the bias voltage of the cascoded n-type FinFET devices, thereby mitigating the risks associated with positive or negative current injection and enhancing the overall robustness and reliability of mixed-voltage systems.

In this disclosure, a voltage sampling circuit and method are described for protecting transistor devices in the voltage sampling circuit against current injection events to address various problems in the art where various limitations and disadvantages of conventional solutions and technologies will become apparent to one of skill in the art after reviewing the remainder of the present application with reference to the drawings and detailed description provided herein. Various illustrative embodiments of the present disclosure will now be described in detail with reference to the accompanying figures. While various details are set forth in the following description, it will be appreciated that the present disclosure may be practiced without these specific details, and that numerous implementation-specific decisions may be made to the disclosure described herein to achieve the device designer's specific goals, such as compliance with process-technology requirements or design-related constraints, which will vary from one implementation to another. While such a development effort might be complex and time-consuming, it would nevertheless be a routine undertaking for those of ordinary skill in the art having the benefit of this disclosure. For example, selected aspects are depicted with reference to a single-ended SAR ADC circuit, though the voltage sampling switch circuit may be used with other applications. Such descriptions and representations are used by those skilled in the art to describe and convey the substance of their work to others skilled in the art. It is also noted that, throughout this detailed description, certain elements in the figures are illustrated for simplicity and clarity and have not necessarily been drawn to scale. Further, reference numerals have been repeated among the drawings to represent corresponding or analogous elements.

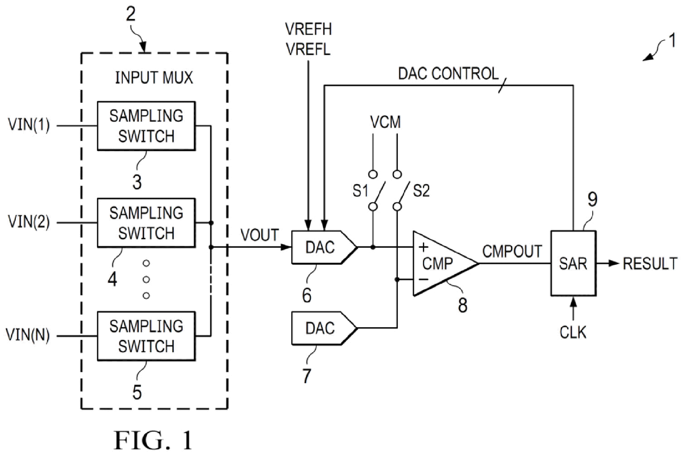

To provide a contextual understanding of selected embodiments of the present disclosure, reference is now made to Figure 1 which depicts a simplified block diagram of a single-ended Successive Approximation Register (SAR) Analog-to-Digital Converter (ADC) 1 with an input multiplexer 2. In the embodiment of Figure 1, the input multiplexer 2 includes a plurality of sampling switch circuits 3-5 which are coupled to receive the input voltages VIN(1), VIN(2), or VIN(N), and is configured to selectively connect one of the outputs from the sampling switch circuits 3-5 to the output voltage terminal VOUT. In addition, the disclosed SAR ADC 1 is connected to receive the output voltage VOUT and to generate the SAR ADC output result using the digital-to-analog converters (DAC) 6, 7, comparator 8, and SAR logic block 9 connected in a feedback loop to provide an n-bit DAC feedback control signal (DAC CONTROL) to the DAC 6, as shown. In this embodiment, the SAR ADC 1 is configured to receive an output voltage signal VOUT from the input multiplexer 2, reference voltages at inputs labeled VREFH and VREFL, a common mode voltage VCM, and a clock signal CLK at an input labeled CLK, and provide an ADC conversion result signal at an output labeled RESULT. In other embodiments, the input multiplexer 2 may be coupled to circuitry of other ADC types such as flash ADCs, sigma-delta ADCs, and others. In yet other embodiments, the input multiplexer 2 may be used in data converters, analog devices, sensors, and other processing devices.

DACs 6 and 7 are configured to receive reference voltages, denoted as VREFH and VREFL. These reference voltages define the range within which the analog input voltage is quantized. The DACs 6 and 7 are controlled by a signal labeled "DAC CONTROL," which dictates the specific analog voltage levels that the DACs output. In particular, the DAC 6 samples the analog input voltage VIN that is selected for output VOUT by the input multiplexer 2 during a sampling phase with a capacitor array (not shown) which includes a plurality of binary weighted capacitors, while the output of DAC 6 is pre-charged to a common mode voltage (VCM) via switches S1, S2. As will be appreciated by those skilled in the art, each binary weighted capacitor corresponds to a binary digit of the binary value obtained from the SAR ADC 1. The bottom plates of the binary weighted capacitors may be switched between a first voltage VREFH, a second voltage VREFL, and the DAC input voltage VOUT, where VREFL < VOUT < VREFH. In similar fashion, the reference DAC 7 is connected to receive the first and second reference voltages VREFH, VREFL. DAC 7 may be a full copy of the binary weighted array or a partial copy that sufficiently matches DAC 6. The bottom plates of capacitors in the reference DAC 7 are not altered during the conversion, thus maintaining output reference voltage Vref near VCM for connection to the inverting input of the comparator 8. Other embodiments may use any type of charge redistribution array for data conversion. In addition, alternate embodiments may use any desired and appropriate elements (e.g., resistive elements, capacitive elements, a combination thereof, etc.).

The comparator 8 is connected to receive the output voltage VOUT from the input multiplexer 2 at its non-inverting input via DAC 6, and is also connected to receive the reference output voltage from the reference DAC 7 at its inverting input. With the outputs from the DACs 6, 7 connected, respectively, as inputs to the non-inverting and inverting terminals, the comparator 8 compares the DAC input voltages to provide a binary output (cmpout) corresponding to each comparison. In selected embodiments, the comparator 8 is an analog voltage comparator having the desired resolution for the n-bit ADC. In addition, the comparator 8 may include additional clock circuitry for generating an asynchronous, self-generated clock signal (not shown) to signal the completion of the compare phase at the comparator 8. The comparator output (cmpout) of comparator 8 is coupled to an input of SAR logic block 9. Comparator 8 provides at the output an output signal (cmpout) indicating a difference between the sampled voltage plus (Vrefh-Vrefl)/2 on the 1^{st} cycle, then the sampled voltage plus (Vrefh-Vrefl)/4 OR 3*(Vrefh-Vrefl)/4, and so on. The + terminal voltage keeps changing in order to do the successive approximation (binary search).

In operation, input multiplexer 2 receives the voltages VIN(1), VIN(2), or VIN(N), and based on a switch control signal (not shown), provides an output voltage signal VOUT at output labeled VOUT. In selected embodiments, the input multiplexer 2 includes sampling switch circuits 3-5 which may be characterized as sample-and-hold circuits. However, it will be appreciated that capacitors in the DAC 6 may be used as the sample and hold circuit, in which case the sampling switch circuits 3-5 are used to connect the desired input voltage to the sample/hold circuits in the DAC 6. For example, when a first SC control signal provided to the sampling switch circuit 3 is at a first logic level (e.g., a logic high), the sampling switch circuit 3 allows sampling of the first input voltage signal VIN(1) and couples the input voltage to the output VOUT. And when the first SC control signal is at a second logic level (e.g., a logic low), the first VIN input is isolated from the output VOUT, allowing the sampled voltage at output VOUT to be sustained or held by way of capacitance coupled to the VOUT output. In similar fashion, SC control signals may be selectively provided to the sampling switch circuits 4, 5 to allow the input voltage signals VIN(2), VIN(N) for coupling to the output VOUT. The input voltages VIN(1), VIN(2), or VIN(N) may exceed a voltage rating for at least some transistors in the input multiplexer 2.

The successive approximation register (SAR) logic block 9 is the digital control and storage element of the SAR ADC 1. The SAR logic block 9 is driven by a clock signal (CLK) and receives the output of the comparator 8 as its input. The SAR logic block 9 implements the successive approximation algorithm to determine the digital representation of the analog input voltage VOUT. The SAR logic block 9 generates a digital output, labeled "RESULT," which represents the digitized value of the selected input voltage. During iterations of the SAR ADC 1, the SAR logic block 9 receives the difference signal from comparator 8 and provides, at an output, the digital DAC control code based on the received difference signal. The DAC 6 receives the digital DAC control code from the SAR 9 at a first input, and one of the reference voltages VREFH, VREFL at a second input. In turn, the DAC 6 provides a first DAC output voltage to the second inverting input of the comparator 8, where the first DAC output voltage is based, at least in part, on the digital DAC control code. In similar fashion, the reference DAC 7 is connected to receive the first and second reference voltages VREFH, VREFL, where the reference DAC 7 may be a full copy of the binary weighted array or a partial copy that sufficiently matches DAC 6. At the end of the analog-to-digital conversion, the digital end of conversion result signal provided at the output of SAR logic block 9 is asserted.

As disclosed herein, the ADC 1 and input multiplexer 2 may be formed as an integrated circuit implemented using a CMOS FinFET process. In some embodiments, ADC 1 and input multiplexer 2 may be integrated in a system-on-a-chip (SoC). As will be appreciated, selected embodiments of the present disclosure may be embodied with differential SAR ADC embodiments in which the first and second digital-to-analog converters (DAC) 6, 7 are replaced with a positive DAC (DAC+) and a negative DAC (DAC-) which are each embodied with capacitor array to respectively provide a positive reference analog voltage V+ and negative reference analog voltage V- to the non-inverting and inverting inputs of a differential comparator 8 which are pre-charged to a common mode voltage (VCM) under control of the feedback comparison control signal. In summary, the SAR ADC circuit takes the selected analog input voltage from the input multiplexer 2, compares it with iteratively generated reference voltages from the DACs 6 and 7, and produces a digital output through the logic implemented in the SAR 9.

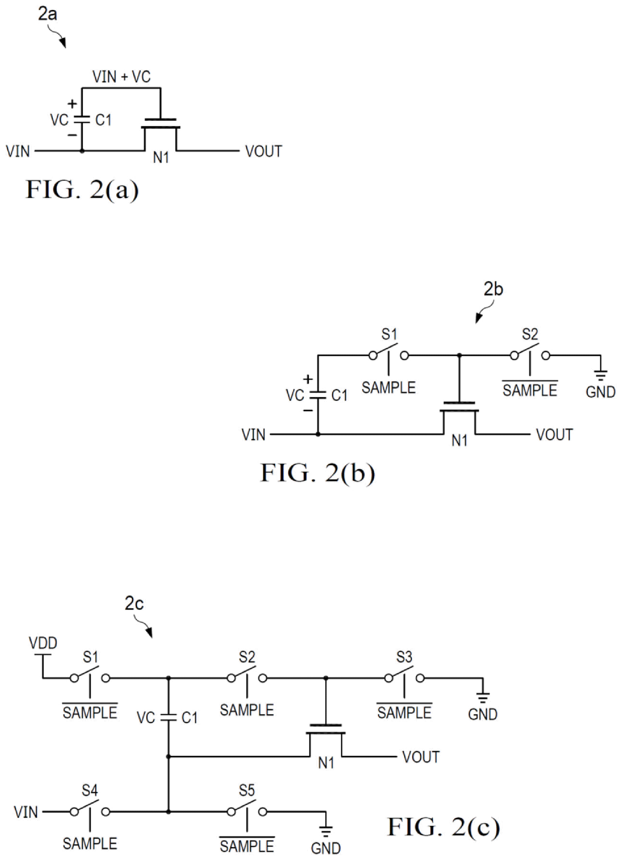

To provide a contextual understanding for the present disclosure, reference is now made to Figure 2A which depicts a simplified circuit schematic of a bootstrap switch circuit 2a. The depicted bootstrap switch circuit 2a includes a capacitor C1 and a transistor N1 connected as a sampling switch as shown, with a control electrode (gate) connected to a first terminal of capacitor C1, a first current electrode connected to a second terminal of capacitor C1 which receives the input voltage VIN, and a second current electrode connected to the output voltage VOUT. With the voltage drop Vc across the capacitor C1, the control electrode of the transistor N1 maintains a constant gate-source voltage (Vgs = (VIN+Vc - VIN) = Vc) on the sampling switch N1, thereby ensuring a relatively constant switch resistance that is independent of the input voltage (VIN). The depicted bootstrap switch circuit 2a ensures that the gate voltage of transistor N1 is Vc higher than VIN. Consequently, the output voltage VOUT samples VIN with a constant resistance.

To provide a contextual understanding for the present disclosure, reference is now made to Figure 2B which depicts a simplified circuit schematic of a track and hold bootstrap switch circuit 2b which includes a capacitor C1 and a transistor N1 having a control electrode that is switched between the capacitor C1 and ground with first and second switches S1, S2 which are controlled by complementary sample switch signals (SAMPLE, SAMPLE_BAR) as shown. The input voltage VIN is connected to a first terminal of capacitor C1 and to a first current electrode of the transistor N1. The second terminal of capacitor C1 is connected over the first switch S1 to the control electrode of the transistor N1, which in turn is connected over the second switch S2 to ground. The second current electrode of the transistor N1 is connected to the output voltage VOUT. During the tracking phase when the first switch S1 is closed and the second switch S2 is open, the control electrode of transistor N1 is connected to the top plate of capacitor C1, resulting in a voltage of VIN + Vc at the control electrode. During the hold phase when the first switch S1 is open and the second switch S2 is closed, the control electrode is discharged to ground via switch S2.

To provide a contextual understanding for the present disclosure, reference is now made to Figure 2C which depicts a simplified circuit schematic of a pre-charge, track and hold bootstrap switch circuit 2c which includes a capacitor C1 and a transistor N1 having a control electrode that is switched between a first terminal of capacitor C1 and ground with second and third switches S2, S3 which are controlled by complementary sample switch signals (SAMPLE, SAMPLE_BAR) as shown. The second terminal of capacitor C1 and the first current electrode of transistor N1 are switched between the input voltage VIN and ground with fourth and fifth switches S4, S5 which are controlled by complementary sample switch signals (SAMPLE, SAMPLE_BAR) as shown. In addition, the first terminal of capacitor C1 is connected to the supply voltage VDD over a first switch S1 which is controlled by the complementary sample switch signal SAMPLE_BAR as shown. In addition, the second current electrode of transistor N1 is connected to the output voltage VOUT. During the tracking phase when the second switch S2 is closed and the third switch S3 is open, the control electrode of transistor N1 is connected to the top plate of capacitor C1, resulting in a voltage of VIN + Vc at the control electrode. During the hold phase when the second switch S2 is open and the third switch S3 is closed, the control electrode is discharged to ground via switch S3. Prior to tracking phase, the capacitor C1 must be pre-charged to Vc, so the control switches S1 and S5 are closed to pre-charge the capacitor C1 to the supply voltage Vdd to pre-charge the capacitor C1 during the hold phase.

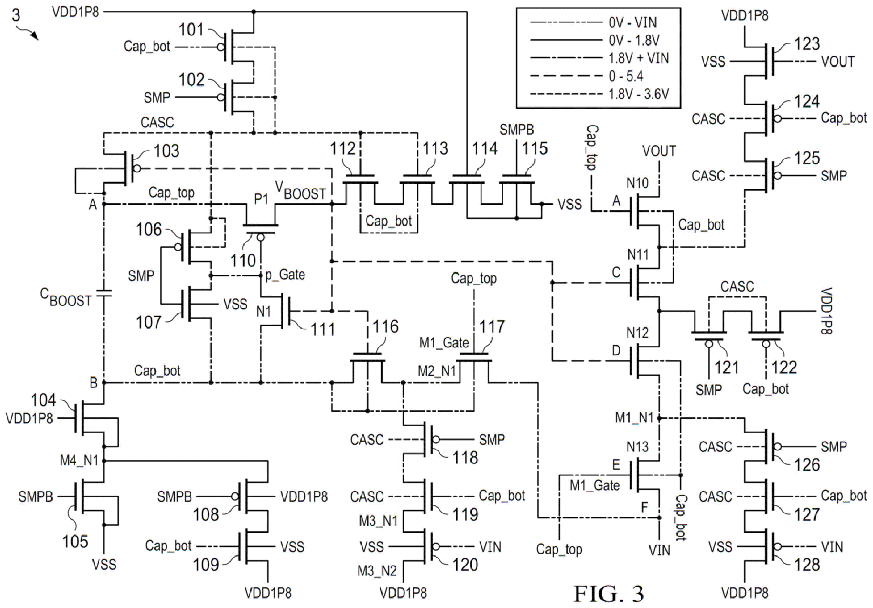

To provide a contextual understanding for the present disclosure, reference is now made to Figure 3 which depicts a schematic circuit diagram of an input voltage sampling switch circuit 3 wherein input over-voltages can cause stress to individual transistor devices from current injection events. The disclosed input voltage sampling switch circuit 3 is configured to receive a first switch control signal SMP (at the control electrodes of transistors 102, 106, 107, 118, 121, 125, 126), a second complementary switch control signal SMPB (at the control electrodes of transistors 105, 108, 115), and the input voltage signal VIN (at the input terminal labeled VIN). As will be known to those skilled in the art, the first and second control signals SMP, SMPB may be generated with a pair of control signal inverters connected in series. The VIN voltage supplied to the input voltage sampling switch circuit 3 may exceed a voltage rating for at least some transistors in switch circuit 3. Based on the SMP, SMPB, and VIN input signals, the switch circuit 3 provides the output voltage signal VOUT at output terminal labeled VOUT. Switch circuit 3 includes a first pre-charge circuit 101-103, a second pre-charge circuit 104/105, a boost capacitor C_{BOOST}, an output disable circuit 112-115, a boost transfer circuit 106/107/110/111/116/117, output switch circuitry N10/N11/N12/N13, voltage maintenance bleeder path circuits 108-109, 118-120, 121-122, 123-125, 126-128, a first supply voltage terminal (labeled VDD1P8), and a second voltage supply terminal VSS (ground). The first supply voltage may be a voltage that is suitable for use with a FinFET IC device, for example, 1.8V.

The first pre-charge circuit includes P-channel transistors 101-103 connected in series between the first supply voltage and a first terminal or top plate of boost capacitor C_{BOOST} (labeled Cap_top). The boost capacitor C_{BOOST} may be formed with any suitable materials and structures available in a given process technology, such as metal-oxide-semiconductor (MOS) capacitors, metal-oxide-metal (MOM) capacitors, metal-insulator-metal (MIM) capacitors, polysilicon-insulator-polysilicon (PIP) capacitors, deep trench capacitors, and the like, for example. The P-channel transistors 101-103 are configured to form a first set of cascoded transistors. In the first set, a first current electrode or source electrode of transistor 101 is connected to the first supply voltage VDD1P8, a second current electrode of transistor 101 is connected to a first current electrode of transistor 102, a control electrode of transistor 102 is coupled to receive the first switch control signal SMP, and a body terminal of transistor 102 is connected to the first supply voltage VDD1P8. A second current electrode of transistor 102 is connected to a first current electrode of transistor 103, a first current electrode of transistor 106 and the control electrodes of transistors 112, 113 at node CASC. The voltage generated at node CASC protects transistors 106, 112, 113 from receiving a voltage beyond an oxide voltage rating of the transistors. A second current electrode or drain electrode of transistor 103 is connected to the top plate of the boost capacitor C_{BOOST} (Cap_top) at node A, to a first current electrode of transistor 110, to a control electrode of transistor N13, and to a control electrode of transistor N10. In Figure 3, the nodes labeled A, E, Cap_top, and M1_Gate are all a single shared net or node. Body terminals of P-channel transistors 103, N12, N13 are connected to each other at the top plate of the boost capacitor C_{BOOST} (Cap_top) at node A such that the body voltage of each of transistors 103, N12, N13 corresponds to the voltage at node A.

The second pre-charge circuit includes N-channel transistors 104 and 105 connected in series between the second supply voltage and a second terminal or bottom plate of boost capacitor C_{BOOST}. The N-channel transistors 104, 105 are configured to form a second set of cascoded transistors. In the second set, a first current electrode of transistor 104 is connected to the bottom plate of the boost capacitor C_{BOOST} at node B, a control electrode of transistor 101, a first current electrode of transistor 107, a first current electrode of transistor 111, a first current electrode and the body terminal of transistor 116, and the body terminals of transistors 112, 113, 117, N10-N13. A second current electrode of transistor 104 is connected to a first current electrode of transistor 105. A control electrode of transistor 104 is connected to the first supply voltage VDD1P8 and a second current electrode of transistor 105 is connected to the second supply voltage shown as ground. A control electrode of transistor 105 is coupled to receive the second complementary switch control signal SMPB.

The boost transfer circuitry includes P-channel transistors 106, 110, N-channel transistors 107, 111 and N-channel transistors 116, 117. A second current electrode of transistor 110 (labeled VBOOST) is connected to a control electrode of transistor 111, a control electrode of transistor 103, a control electrode of transistor 116, a first current electrode or drain electrode of transistor 112, and the control electrodes of transistors N11, N12. A control electrode of transistor 110 is connected to a second current electrode of transistor 106, a second current electrode of transistor 107, and a second current electrode of transistor 111. The control electrodes of transistors 106 and 107 are each coupled to receive the second complementary switch control signal SMPB. A first current electrode of transistor 107 and a first current electrode of transistor 111 are each connected **to** the bottom plate of the boost capacitor C_{BOOST} at node B.

The output disable circuitry includes N-channel transistors 112-115 connected in series between the second supply voltage VSS and the VBOOST node. The N-channel transistors 112-115 are configured to form a third set of cascoded transistors. In the third set, a second current electrode of transistor 112 is connected to a first current electrode of transistor 113, and a second current electrode of transistor 113 is connected to a first current electrode of transistor 114, and a second current electrode of transistor 114 is connected to a first current electrode of transistor 115. A second current electrode or source electrode of transistor 115 is connected to the second supply voltage. The control electrode of transistor 114 is connected to the first supply voltage VDD1P8, and the control electrode of transistor 115 is coupled to receive the second complementary switch control signal SMPB.

The output switch circuitry includes N10-N13 connected in series between node B and the VOUT terminal and configured to form a fourth set of cascoded transistors. In the fourth set, a first current electrode of transistor N13 is connected to the input voltage terminal VIN, and a second current electrode of transistor N13 is connected to a first current electrode of transistor N12, and a second current electrode of transistor N12 is connected to a first current electrode of transistor N11, and a second current electrode of transistor N11 is connected to a first current electrode of transistor N10, and a second current electrode of transistor N10 is connected to the VOUT terminal. In this embodiment, body electrodes of transistors N10-N13 are each connected to the bottom capacitor plate (node B). The control electrodes of transistors N11, N12 are each connected to node VBOOST, and the control electrodes of transistors N10, N13 are each connected to node A. Though not shown, a load capacitor may be connected to the VOUT terminal, and may include intrinsic capacitance of circuitry connected to the VOUT terminal.

Each of the voltage maintenance bleeder path circuits (e.g., 108-109) include a plurality of transistors that are connected in series and configured to form a set of cascoded transistors between the first supply voltage VDD1P8 and an internal node where the voltage is maintained in response to control signals supplied to the control electrodes of the cascoded transistors. For example, the first voltage maintenance bleeder path circuit includes a P-channel transistor 108 and an N-channel transistor 109 connected in series between the shared current electrode of transistors 104, 105 and the first supply voltage VDD1P8. In the first voltage maintenance bleeder path circuit, the first current electrode of transistor 108 is connected to the shared current electrode of transistors 104, 105, the second current electrode of transistor 108 is connected to a first current electrode of transistor 109, the control electrode of transistor 108 connected to receive the SMPB signal, and the body terminal is connected to the first supply voltage VDD1P8. In addition, the second current electrode of transistor 109 is connected to the first supply voltage VDD1P8, the control electrode of transistor 109 connected to the bottom plate of the boost capacitor C_{BOOST}, and the body terminal is connected to the second supply voltage VSS.

In another example, a second voltage maintenance bleeder path circuit includes a P-channel transistor 126, an N-channel transistor 127, and a P-channel transistor 128 connected in series between the shared current electrode of transistors N12, N13 and the first supply voltage VDD1P8. In the second voltage maintenance bleeder path circuit, the first current electrode of transistor 126 is connected to the shared current electrode of transistors N12, N13, the second current electrode of transistor 126 is connected to a first current electrode of transistor 127, the control electrode of transistor 126 connected to receive the SMP signal, and the body terminal is connected to the cascode voltage CASC which is created in the pre-charge path. When not sampling, the cascode voltage CASC gets pulled to VDD1P8 (same as cap_top). When sampling, the cascode voltage CASC goes to VIN+VDD1P8 (if VIN>VDD1P8) or stays at VDD1P8 (if VIN< VDD1P8). It is there to cascode, or prevent excess voltage, on various transistors, especially in the control switch S3. It also biases the bulk of a number of devices. In addition, the second current electrode of transistor 127 is connected to the first current electrode of the transistor 128, the control electrode of transistor 127 is connected to the bottom plate of the boost capacitor C_{BOOST}, and the body terminal is connected to the CASC voltage. In addition, the second current electrode of transistor 128 is connected to the first supply voltage VDD1P8, the control electrode of transistor 128 connected to the input voltage VIN, and the body terminal is connected to the second supply voltage VSS.

Operation of the sampling switch circuit 3 is described further by way of example. In this example, the first and second switch control signals SMP, SMPB are each characterized as a digital signal that toggles between a logic low level (e.g., ground) and a logic high level (e.g., VDD1P8), and may have a periodic waveform much like a clock signal, for example. When the SMP signal is at a logic high, the sampling switch circuit 3 is characterized as being in a sample phase of operation. When the SMP signal is at a logic low, the sampling switch circuit 3 is characterized as being in a pre-charge phase of operation.

When the SMP signal is de-asserted as a logic low, the sampling switch circuit 3 enters the pre-charge phase of operation. During the pre-charge phase, the transistors of the first pre-charge circuit 101/102/103 and the transistors of the second pre-charge circuit 104/105 are turned ON, pre-charging the boost capacitor C_{BOOST} to an initial voltage. In this example, VIN is an analog voltage signal that may vary between two times VDD1P8 (VDD1P8*2) and ground (e.g., 0 volts). For example, the sampling switch circuit 3 may be formed in a process technology having VDD1P8=1.8 volts. Accordingly, VIN may vary between 3.6 volts and 0 volts. The output switch circuitry N10/N11/N12/N13 is configured in an OFF state, isolating VIN from VOUT. While the output switch circuitry N10/N11/N12/N13 is configured in the OFF state, the voltage at VOUT corresponds to a sampled voltage stored on the load capacitor (not shown). Internal node CASC is pre-charged to a voltage approximately equal to VDD1P8, and internal node VBOOST is pre-charged to a voltage approximately equal to 0 volts or ground.

When the SMP signal is asserted as a logic high, the sampling switch circuit 3 enters the sample phase of operation. During the sample phase, a transistor in each of the first pre-charge circuit 101/102/103, the second pre-charge circuit 104/105, and the disable circuitry 112-115 is turned OFF, isolating the first and second pre-charge circuits and the boost transfer circuit 106/107/110/111 from the first supply voltage (e.g., VDD1P8) and from the second supply voltage (ground), respectively. A voltage stored on boost capacitor C_{BOOST} is coupled to the CASC and VBOOST nodes accordingly. In this example, CASC is an analog voltage signal at the internal node labeled CASC and, based on the VIN voltage signal, may vary between approximately two times VDD1P8 and VDD voltages. VBOOST is an analog voltage signal at the internal node labeled VBOOST and, based on the VIN voltage signal, may vary between approximately three times VDD1P8 (VDD1P8*3) and ground voltages. For example, sampling switch circuit 3 may be formed in a process technology having VDD1P8=1.8 volts. Accordingly, VBOOST may vary between 5.4 volts and 0 volts.

Because transistors 116, 117, N10-N13 of the output switch circuitry are in the ON state during the sample phase, a voltage VIN at the VIN input is sampled and provided at the output labeled VOUT. While in the sample phase, the CASC, VBOOST, and Node B voltages track with changes in the VIN voltage, providing corresponding transistor voltages within allowable voltage tolerances specified for a given process technology. With the body terminals of transistors 116, 117, N10-N13 connected to Node B, a constant gate-to-source voltage and constant bulk-to-source voltage can be maintained. Accordingly, a significantly more linear resistance is realized from VIN to VOUT.

During each pre-charge phase, the transistors 101-106, 112-115 are in an ON state, and the transistors 107, 110-111, 116-117, and N10-N13 are in an OFF state. As a result, the voltage range for individual paths in the sampling switch circuit 3 are identified with the legend of voltage range values with line identifiers. When the sampling switch circuit 3 is in pre-charge mode with VDD1P8 = 1.62V, the input voltage VIN can go to 3.6V. The voltage on node M1_N1 would be 1.62 -Vth_N13 (without the bleeder circuit). This would cause a Safe Operating Area (SOA) violation (Vds) for transistor N13. For node M2_N1, the voltage would be 1.62 - Vth_117 (without the bleeder circuit). This would cause a Vds SOA for transistor 117. The voltage difference between source and drain of transistors N13 and 117 cause SOA violations. Accordingly, the voltage maintenance bleeder path circuit 126-128 (for N13) and 118-120 (for 116) are included as bleeder paths to set the required node voltage at 1.62 V.

During each tracking phase, the transistors 101-106, 112-115 are in an OFF state, and the transistors 107, 110-111, 116-117, and N10-N13 are in an ON state. As a result, the voltage range for individual paths in the sampling switch circuit 3 are identified with the legend of voltage range values with line identifiers. When the sampling switch circuit 3 is in sample mode, the bottom capacitor plate voltage (cap_bot) can go to 3.6V. Node M4_N1 is set at 1.62V - Vth_104 (without the bleeder circuit). The voltage difference between source and drain of transistor 104 causes an SOA violation. Accordingly, the voltage maintenance bleeder path circuit 108-109 is included as a bleeder path to make the node voltage 1.62.

While the sampling switch circuit 3 performs well in its tracking and pre-charging states, problems can arise when current injection events arise which cause the input voltage (VIN) to reach voltages higher than twice the first supply voltage (positive current injection) or lower than the second supply voltage (negative current injection). When such current injection events occur, the transistor devices with any of their nodes connected to the input voltage VIN will get overstressed. In the depicted sampling switch circuit, the transistors 117, 120, N13, and 128 are in direct contact with the input voltage VIN. In situations where the input voltage VIN exceeds twice the supply voltage (e.g., VIN > 2xVDD1P8 or 3.3V/3.6V), powered current injection can increase the gate-source voltage, thereby stressing the transistor devices that are connected directly to the voltage input VIN (e.g., 117, 120, 128, N13) so that there are in immediate danger of an SOA violation in presence of positive or negative current injection from the input voltage VIN.

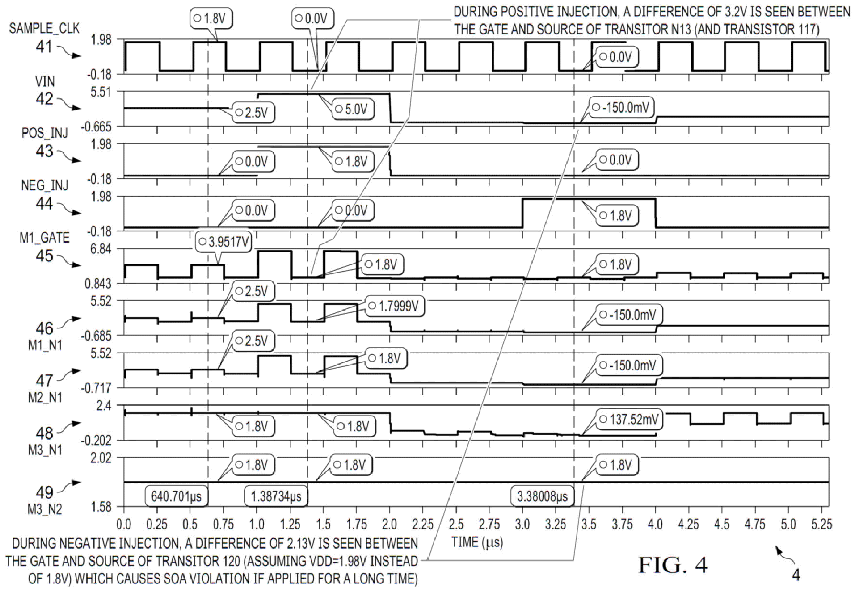

To illustrate the potential negative effects from positive and negative current injection, reference is now made to Figure 4 which shows voltage timing signals 41-49 seen by transistor devices in the input voltage sampling switch circuit during negative and positive current injection events. In particular, the SAMPLE_CLK waveform 41 corresponds to the switch control signal SMP provided to the input voltage sampling switch circuit. In addition, the VIN waveform 42 corresponds to the input voltage VIN provided to the input voltage sampling switch circuit. As illustrated, the VIN waveform 42 starts at 2.5V (which does not exceed 2XVDD1P8). At time t=1.0 µs, the VIN waveform 42 rises above twice the voltage supply to 5V to create a positive current injection event. And at time t=2.0 µs, the VIN waveform 42 falls below ground to -150mV to create a negative current injection event. In this simulation, the input voltages Vin = 5V and Vin = -150mV were selected to create the positive and negative injection scenarios. As depicted, the circuit is not having any issues even up to 5V on the positive side. It will be robust for similar magnitude on negative side also. If we inject the current, then voltages that would appear on the PAD should be almost symmetrical for positive/negative injection. For positive current injection, it will be slightly higher as all the current would flow through the ESD diode, and for negative current injection, a part of current can flow through sample switch also. To indicate the occurrence of a positive current injection event, the depicted POS_INJ waveform 43 is shown at 0V when there is no positive current injection event, and then rises to VDD1P8=1.8V only when there is a positive current injection event. And to indicate the occurrence of a negative current injection event, the depicted NEG_INJ waveform 44 is shown at 0V when there is no negative current injection event, and then rises to VDD1P8=1.8V only when there is a negative current injection event.

With respect to transistor device N13, the depicted M1_GATE waveform 45 depicts the gate voltage at transistor device N13, the depicted M1_N1 waveform 46 depicts the voltage at the first node of transistor device N13, and the depicted VIN waveform 42 depicts the voltage at the second node of transistor device N13. During normal operation, the gate voltage at transistor device N13 switches between 1.8V and 3.9517V, but jumps up to a higher voltage (approaching 6.84V) during positive current injection events, resulting in a difference of 3.2V between the gate and the second node of transistor device N13 that can overstress transistor device N13.

With respect to transistor device 117, the depicted M1_GATE waveform 45 depicts the gate voltage at transistor device 117, the depicted VIN waveform 42 depicts the voltage at the first node of transistor device 117, and the depicted M2_N1 waveform 47 depicts the voltage at the second node of the transistor device 117. During normal operation, the gate voltage at transistor device 117 switches between 1.8V and 3.9517V, but jumps up to a higher voltage (approaching 6.84V) during positive current injection events, resulting in a difference of ~3.2V between the gate and the second node of transistor device 117 that can overstress transistor device 117.

With respect to transistor device 120, the depicted VIN waveform 42 depicts the gate voltage at transistor device 120, the depicted M3_N1 waveform 48 depicts the voltage at the first node of transistor device 120, and the depicted M3_N2 waveform 49 depicts the VDD1P8 voltage at the second node of transistor device 120. A difference of 2.13V is seen between the gate and the second node of transistor device 120 (assuming VDD=1.98V instead of 1.8V). This voltage applied for a very long time causes excessive transistor aging and can result in transistor failure. As will be appreciated, the gate, source and drain voltages for the transistor device 128 are similar to those for transistor device 120, and are therefore not repeated here.

As seen from the foregoing, existing sampling switch circuits perform well during tracking and pre-charging states when the input voltage stays between twice the first supply voltage (e.g., 2xVDD1P8) and the second supply voltage (ground), but there are challenges that remain caused by current injection events which can damage transistors connected to the input voltage VIN when it exceeds twice the first supply voltage (e.g., 2xVDD1P8) or goes below the second supply voltage (ground). As will be appreciated, current injection events can be caused by electrostatic discharge (ESD) events. Another cause of current injection events occurs when the ADC inputs on an MCU are combined onto a general purpose pin such that a customer could use the pin for digital I/O or as an ADC input. Because of this, some of the ADC channels can be connected to pins/pads functioning as digital I/O. These I/O can exceed the supplies during switching events, or they could be driven by external circuitry beyond the desired supply range. To address these deficiencies with existing sampling switch circuits and others known to those skilled in the art, the present disclosure proposes to detect positive and negative current injection events, and to keep "at risk" transistor devices with nodes connected to the input voltage VIN within allowed stress limits by adjusting the gate bias voltages of such "at risk" transistor devices during current injection events so that the gate bias voltages for "at risk" transistor devices are switched to the second supply voltage or "ground" during negative current injection events, and so that the gate bias voltages for "at risk" transistor devices are switched to approximately 3.3V during positive current injection events. Generally speaking, the disclosed sampling switch circuit uniquely provides injection detection logic within the input pad wherein negative and positive comparators connected to the input pad which are each connected to compare the pad voltage to a reference comparison voltage. During a negative injection event, the pad voltage will go below a first reference comparison voltage (e.g., ground), causing the negative comparator output to go high. And during a positive injection event, the pad voltage will go above a second reference comparison voltage (e.g., 3.3V), causing the positive comparator output to go high. In addition, the disclosed sampling switch circuit provides control switching signals and switching circuitry for regulating the gate bias voltages of the output switch transistor devices and other "at risk" transistor devices during current injection events to protect such transistor devices from being overstressed. In operation, the control switching signals and switching circuitry function as safety switches that kick in during a pre-charge mode when the injection detector senses a current injection event, thereby preventing tracking or sampling during current injection events.

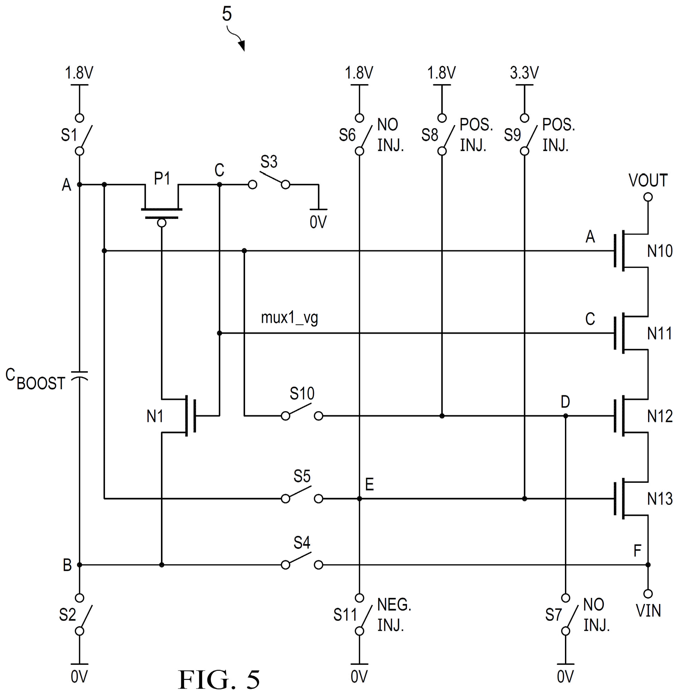

For an improved understanding of selected embodiments of the present disclosure, reference is now made to Figure 5 which illustrates a simplified circuit schematic of an input voltage sampling switch circuit 5 which includes a boost capacitor C_{BOOST}, first and second pre-charge circuits S1, S2, a boost transfer circuit P1, N1, an output switch circuit N10-N13 connected between the input voltage VIN and output voltage VOUT, and control switching circuitry S3-S11 which are selective switched to manage the connection of the boost transfer circuit to the output switch circuit while protecting the gate bias voltages of the output switch transistor devices (e.g., N13) that are directly connected to the input voltage VIN during current injection events to protect such transistor devices from being overstressed.

In operation, the first and second pre-charge circuits S1, S2 are connected to manage the charging of the boost capacitor C_{BOOST} to specific voltage levels (first and second supply voltages) at appropriate times. In particular, the first pre-charge circuit S1 is connected between the first supply voltage (e.g., 1.8V) and a first terminal or top plate of boost capacitor C_{BOOST}. In addition, second pre-charge circuit S2 is connected between the second supply voltage (e.g., 0V) and a second terminal or bottom plate of boost capacitor C_{BOOST}.

During a pre-charge phase of operation when there is no sampling, the first and second pre-charge circuits S1, S2 are turned ON to pre-charge boost capacitor C_{BOOST} to an initial voltage (e.g., VDD = 1.8V). In addition, the control switch S4 is turned OFF or opened during the pre-charge phase to disconnect the input voltage VIN from the bottom plate of the boost capacitor C_{BOOST}. In addition, the disable control switch S3 and control switch S10 are turned ON or closed to connect the control gate electrodes of N11, N12 to the second supply voltage (ground), thereby disconnecting the MUX input path between VIN and VOUT by the turning OFF the output switch transistors N11-N12. In addition, the control switch S5 is turned ON or closed to connect the control gate electrodes of N13 and N10 to the node A which is connected over the first pre-charge circuit S1 to the first supply voltage (e.g., 1.8V).

During the sample phase of operation, the first and second pre-charge circuits S1, S2 and the disable control switch S3 are turned OFF, isolating the boost capacitor C_{BOOST} from the first and second supply voltages. In addition, the control switch S4 is closed or turned ON during the sampling phase to connect the input voltage VIN to the bottom plate of the boost capacitor C_{BOOST}. During the sampling phase, the boost transfer circuit P1, N1 is connected to boost the voltage from the boost capacitor C_{BOOST} at the boosted voltage node C. In addition, the control switching circuitry S4-S11 is configured to connect the boosted voltage nodes A and C to drive the gates A/C/D/E of the output switch transistors N10-N13 which are connected as a series of cascoded n-type FinFET devices to serve as a MUX input path between the input voltage VIN and the output voltage VOUT. In particular, the control switching circuitry S4-S11 are configured to regulate the gate bias voltage of the output switch FinFET devices to protect against current injection events.

When there is no current injection event detected, the control switches S6, S11 are closed or turned ON, and the control switches S7-S9 are open. As a result, the voltage at node A (VIN + 1.8V) is connected to the control gate electrode of N10, and is also connected over the control switch S5 to the control gate electrode of N13. And because the P-channel transistor P1 is turned ON or closed, the voltage at node A (VIN + 1.8V) will be connected over the P-channel transistor P1 to node C which is connected to the control gate electrode of N11, and is also connected over the control switch S10 to the control gate electrode of N12. As a result, all of the output switch transistors N10-N13 will each receive a gate bias voltage of approximately VIN + 1.8V, and the input voltage VIN will be connected over the output switch transistors N10-N13 to generate the output voltage VOUT which will be sampled within the ADC.

If there is current injection event detected, the sample switch is turned OFF and the control switches S6-S11 are configured to protect transistor devices in the input voltage sampling switch circuit (e.g., N13) from positive/negative injection events. If there is no current injection and the input voltage sampling switch circuit is in the sample phase of operation, then control switches S6-S11 are all turned OFF during the sampling phase. And during the pre-charge phase with no current injection events, the control switches S6 and S11 will be turned ON and the control switches S7, S8, and S9 will be turned OFF.

In particular, when there is a positive current injection event detected, the switch is configured in precharge state/switch does not sample. The control switches S1, S2, S3, S8, S9 are closed or turned ON, and the control switches S4, S5, S6, S7, S10, S11 are open. As a result, the voltage at node A (1.8V) is connected to the control gate electrode of output switch transistor N10, but is disconnected from the control gate electrode of output switch transistor N13 by the control switch S5. Instead, the control switch S9 connects an elevated supply voltage (e.g., 3.3V) to node E at the control gate electrode of output switch transistor N13. And because the control switch S3 is turned ON or closed, the voltage at node C (0V) will be connected to the control gate electrode of output switch transistor N11, but is disconnected from the control gate electrode of output switch transistor N12 by the control switch S10. Instead, the control switch S8 connects the first supply voltage (e.g., 1.8V) to node D at the control gate electrode of output switch transistor N12. As a result, the output switch transistor N10 will receive a gate bias voltage of 1.8V, output switch transistor N11 will receive a gate bias of 0V, output switch transistor N12 will receive a gate bias voltage of approximately 1.8V, and the output switch transistor N13 will receive a gate bias voltage of approximately 3.3V to protect the output switch transistors N13 and N12from positive current injection.

When there is a negative current injection event detected, the switch is configured in precharge state/switch does not sample. The control switches S1, S2, S3, S7, S10 are closed or turned ON, and the control switches S4, S5, S6, S8, S9, S11 are open. As a result, the voltage at node A (1.8V) is connected to the control gate electrode of output switch transistor N10, but is disconnected from the control gate electrode of N13 by the control switch S5. Instead, the control switch S7 connects the second supply voltage (e.g., 0V) to node E at the control gate electrode of output switch transistor N13. And because the control switch S3 is turned ON or closed, the voltage at node C (0V) will be connected to the control gate electrode of output switch transistor N11, and is also connected over the control switch S10 to the control gate electrode of output switch transistor N12. As a result, the output switch transistor N10 will receive a gate bias voltage of 1.8V, and the output switch transistors N11, N12 and N13 will each receive a gate bias voltage of 0V to protect the output switch transistor N13 transistor from negative current injection.

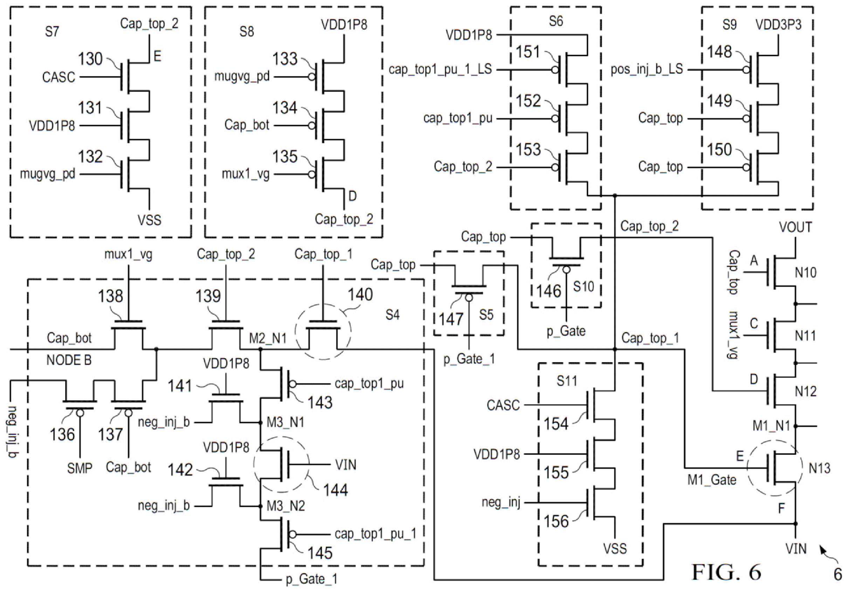

To provide additional details for an improved understanding of selected first embodiments of the present disclosure, reference is now made to Figure 6 which depicts a detailed circuit schematic 6 of control switches S4-S11 which may be connected to the output switch transistors N10-N13 of an input voltage sampling switch circuit, such as depicted in Figure 5. Each control switch S4-S11 in Figure 6 corresponds to the simple switches S4-S11 in Figure 5, but include additional circuit connection details.

For example, control switch S7 includes a cascoded plurality of NFET transistors 130-132 that are connected in series between the node D (Cap_top_2) and the second supply voltage VSS. The first NFET transistor 130 has a control electrode (gate) connected to receive the CASC control signal. The second NFET transistor 131 has a control electrode (gate) connected to receive the first supply voltage VDD1P8 as a control signal. The third NFET transistor 132 has a control electrode (gate) connected to receive the mugvg_pd control signal which is generated as described hereinbelow. In this way, the NFET transistors 130-132 of the control switch S7 operatively connect the control electrode of transistor N12 by connecting node D to ground when there is a positive current injection event signaled by the muxvg_pd control signal being at a second logic level (e.g., a logic LOW).

In addition, control switch S8 includes a cascoded plurality of PFET transistors 133-135 that are connected in series between the first supply voltage VDD1P8 and node D (Cap_top_2). The first PFET transistor 133 has a control electrode (gate) connected to receive the mugvg_pd control signal which is generated as described hereinbelow. The second PFET transistor 134 has a control electrode (gate) connected to receive the Cap_bot control signal. The third PFET transistor 135 has a control electrode (gate) connected to receive the mux1_vg control signal which is generated as described hereinbelow. In this way, the PFET transistors 133-135 of the control switch S8 operatively connect the control electrode of transistor N12 by connecting node D to first supply voltage VDD1P8 when there is a positive current injection event signaled by the mugvg_pd control signal being at a second logic level (e.g., a logic LOW).

In addition, control switch S4 includes a cascoded plurality of NFET transistors 138-140 that are connected in series between node B (Cap_bot) and node F (VIN). The first NFET transistor 138 has a control electrode (gate) connected to receive the muxvg_1 control signal. The second NFET transistor 139 has a control electrode (gate) connected to receive the Cap_top_2 control signal. The third NFET transistor 140 has a control electrode (gate) connected to receive the Cap_top_2 control signal. In addition, the shared source/drain node between the NFET transistors 138, 139 is connected over a cascoded plurality of PFET transistors 136-137 to the complementary negative injection control signal (neg_inj_b), where a first PFET transistor 136 has a control electrode (gate) connected to receive the first switch control signal SMP, and where a second PFET transistor 137 has a control electrode (gate) connected to receive the Cap_bot control signal. In addition, the shared source/drain node between the NFET transistors 139, 140 is connected over a cascoded plurality of transistors 143-145 to the control signal (p_Gate_1) which is generated as described hereinbelow, where a first PFET transistor 143 has a control electrode (gate) connected to receive the cap_top1_pu control signal, where a second NFET transistor 144 has a control electrode (gate) connected to receive the input voltage VIN, and where a third PFET transistor 145 has a control electrode (gate) connected to receive the cap_top1_pu_1 control signal. In this way, the transistors 136-145 of the control switch S4 operatively connect the bottom plate of the boost capacitor C_{BOOST} (at node B) to the input voltage VIN (at node F) in response to the input control signals for control switch S4.

In addition, control switch S5 includes a PFET transistor 147 that is connected between node A (Cap_top) and node E (Cap_top_1). The PFET transistor 147 has a control electrode (gate) connected to receive the control signal (p_Gate_1) which is generated as described hereinbelow. In this way, the PFET transistor 147 of the control switch S5 operatively connects the top plate of the boost capacitor (at node A) to the control electrode of transistor N13 (at node E) in response to the p_Gate_1 control signal for control switch S5.

In addition, control switch S10 includes a PFET transistor 146 that is connected between node A (Cap_top) and node D (Cap_top_2). The PFET transistor 146 has a control electrode (gate) connected to receive the control signal (p_Gate) which is generated as described hereinbelow. In this way, the PFET transistor 146 of the control switch S10 operatively connects the top plate of the boost capacitor (at node A) to the control electrode of transistor N12 (at node D) in response to the p_Gate control signal for control switch S10.

In addition, control switch S6 includes a cascoded plurality of PFET transistors 151-153 that are connected in series between the first supply voltage VDD1P8 and node E (Cap_top_1). The first PFET transistor 151 has a control electrode (gate) connected to receive the cap_top1_pu_1_LS control signal which is generated as described hereinbelow. The second PFET transistor 152 has a control electrode (gate) connected to receive the cap_top1_pu control signal. The third PFET transistor 153 has a control electrode (gate) connected to receive the Cap_top_2 control signal which is generated as described hereinbelow. In this way, the PFET transistors 151-153 of the control switch S6 operatively connect the control electrode of transistor N13 by connecting node E to the first supply voltage VDD1P8 when there is no current injection event signaled by the cap_top1_pu_1_LS control signal, cap_top1_pu control signal, and the Cap_top_2 control signal being at a second logic level (e.g., a logic LOW).

In addition, control switch S9 includes a cascoded plurality of PFET transistors 148-150 that are connected in series between the elevated supply voltage VDD3P3 and node E (Cap_top_1). The first PFET transistor 148 has a control electrode (gate) connected to receive the level shifted complementary positive injection control signal (pos_inj_b_LS) which is generated as described hereinbelow. The second PFET transistor 149 has a control electrode (gate) connected to receive the Cap_top control signal. The third PFET transistor 150 has a control electrode (gate) connected to receive the Cap_top control signal which is generated as described hereinbelow. In this way, the PFET transistors 148-150 of the control switch S9 operatively connect the control electrode of transistor N13 by connecting node E to the elevated supply voltage VDD3P3 when there is a positive current injection event signaled by the pos_inj_b_LS control signal and the cap_top control signal being at a first logic level (e.g., a logic HIGH).

In addition, control switch S11 includes a cascoded plurality of NFET transistors 154-156 that are connected in series between node E (Cap_top_1) and the second supply voltage VSS. The first NFET transistor 154 has a control electrode (gate) connected to receive the CASC control signal. The second NFET transistor 155 has a control electrode (gate) connected to receive the first supply voltage VDD1P8. The third NFET transistor 156 has a control electrode (gate) connected to receive the negative injection control signal (neg_inj) which is generated as described hereinbelow. In this way, the NFET transistors 154-156 of the control switch S11 operatively connect the control electrode of transistor N13 by connecting node E to the second supply voltage VSS when there is a current injection event signaled by the negative injection control signal (neg_inj) being at a first logic level (e.g., a logic HIGH).

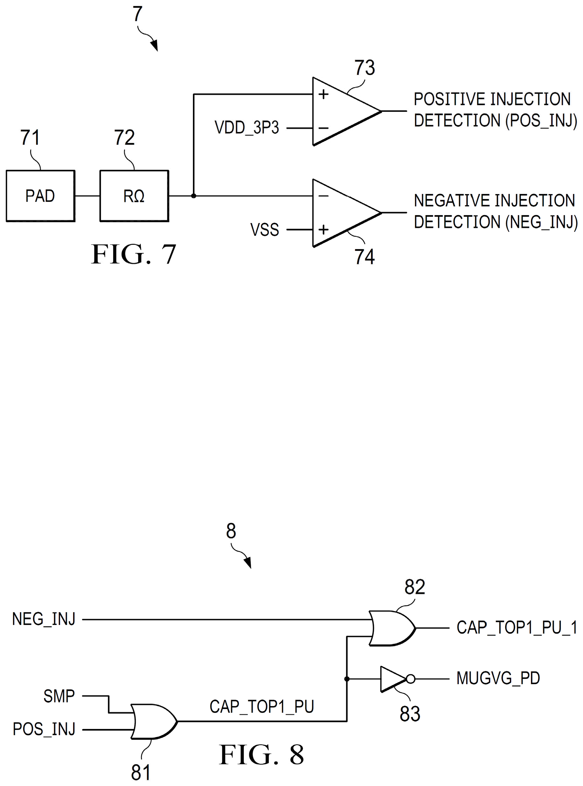

For an improved understanding of selected embodiments of the present disclosure, reference is now made to Figure 7 which illustrates a simplified schematic block diagram of a current injection detector 7 for detecting positive and negative current injection events. The disclosed current injection detector 7 includes an input pad 71 connected over a resistance load 72 to a positive injection comparator circuit 73 and a negative injection comparator circuit 74. At the positive injection comparator circuit 73, the input voltage is connected to the non-inverting input terminal and a first reference comparison voltage (e.g., VDD_3P3 = 3.3V), such as an elevated supply voltage, is connected to the inverting input terminal. During any positive current injection event when the input voltage exceeds the first reference comparison voltage, the positive injection comparator circuit 73 is configured to generate a positive injection detection signal (pos_inj). In similar fashion, the negative injection comparator circuit 74 is connected to receive the input voltage at the inverting input terminal, and is connected to receive a second reference comparison voltage (e.g., VSS = 0V) at the non-inverting input terminal. During any negative current injection event when the input voltage is less than the second reference comparison voltage, the negative injection comparator circuit 74 is configured to generate a negative injection detection signal (neg_inj). In this way, the current injection detector 7 may be used to detect the presence and type of any current injection event.

For an improved understanding of selected embodiments of the present disclosure, reference is now made to Figure 8 which illustrates a simplified schematic block diagram of a control signal generator 8 which generates switching control signals in response to the positive and negative current detection signals. The disclosed control signal generator 8 includes a first OR gate 81, second OR gate 82, and inverter 83 connected as shown to generate the switching control signals CAP_TOP1_PU_1 and MUGVG_PD in response to the positive and negative current detection signals under control of the switch control signal SMP. At the first OR gate 81, the positive current injection signal (POS_INJ) and switch control signal SMP are logically combined with the logical OR function to generate the cap_top1_pu control signal which is HIGH when either the positive current injection signal (POS_INJ) or the switch control signal SMP is HIGH. At the second OR gate 82, the negative current injection signal (NEG_INJ) and cap_top1_pu control signal are logically combined with the logical OR function to generate the cap_top1_pu_1 control signal which is HIGH when either the negative current injection signal (NEG_INJ) or the cap_top1_pu_1 control signal is HIGH. At the inverter 83, the MUGVG_PD is generated by inverting the cap_top1_pu_1 control signal.

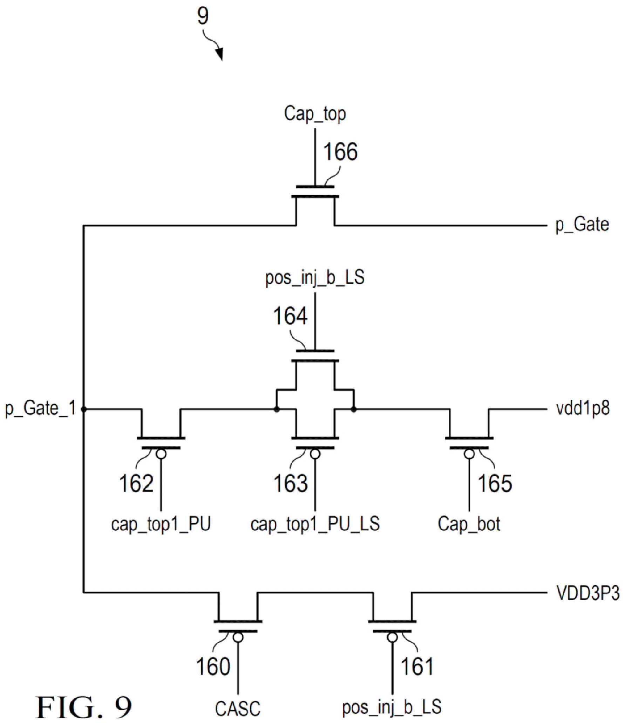

For an improved understanding of selected embodiments of the present disclosure, reference is now made to Figure 9 which illustrates is a simplified circuit schematic of a control signal generator 9 for generating the p_gate_1 control signal in response to the input switching control signals. The disclosed control signal generator 9 includes three circuit branches for generating the p_gate_1 control signal, depending on whether the input voltage sampling switch circuit is positive injection or negative injection or normal functional operation.

In a first circuit branch, an NFET transistor 166 is connected to receive the p_gate control signal and to generate the p_gate_1 control signal. The control gate electrode of the NFET transistor 166 is connected to the Cap_top control signal. In this way, the transistor 166 of the first circuit branch operatively generates the p_gate_1 control signal during sample mode of the normal functional operation.

In a second circuit branch, a cascoded plurality of PFET transistors 162, 163, 165 and an NFET transistor 164 are connected as shown to receive the first supply voltage VDD1P8 and to generate the p_gate_1 control signal. The first PFET transistor 162 has a control electrode (gate) connected to receive the cap_top1_pu control signal. The second PFET transistor 163 has a control electrode (gate) connected to receive the cap_top1_pu_LS control signal, and is connected in parallel with the NFET transistor 164 which has a control electrode (gate) connected to receive the pos_inj_b_LS control signal. The third PFET transistor 165 has a control electrode (gate) connected to receive the Cap_bot control signal. In this way, the transistors 162-165 of the second circuit branch operatively generates the p_gate_1 = 1.8V during pre-charging operations and in the absence of a positive current injection event.

In a third circuit branch, a cascoded plurality of PFET transistors 160, 161 are connected as shown to receive the elevated supply voltage VDD3P3 and to generate the p_gate_1 control signal. The first PFET transistor 160 has a control electrode (gate) connected to receive the CASC control signal. The second PFET transistor 161 has a control electrode (gate) connected to receive the pos_inj_b_LS control signal. In this way, the transistors 160-161 of the third circuit branch operatively generates the p_gate_1 = 3.3V during a positive current injection event.

Operation of a sampling switch circuit disclosed herein is described further by way of an example of the control switches S4-S11 shown in Figure 6 which are connected to control the gate bias voltages of output switch transistors N10-N13 shown in Figure 5. In this example, the first and second switch control signals SMP, SMPB are complementary or inverted digital signals that toggle between a logic low level (e.g., ground) and a logic high level (e.g., VDD1P8), and may have a periodic waveform.

When the SMP signal is de-asserted as a logic LOW, the sampling switch circuit enters the pre-charge phase of operation. During the pre-charge phase, the transistors of the first and second pre-charge circuits S1, S2 and the disable control switch S3 are turned ON to pre-charge the boost capacitor C_{BOOST} to an initial voltage. In this example, VIN is an analog voltage signal that may exceed an upper threshold value of twice the first supply voltage (e.g., VDD1P8*2) and may go below the second supply voltage (e.g., 0 volts). During the pre-charge phase, the control switches S5, S8- S11, output switch circuit transistors N10-N13, and transistors 136-142 (from Figure 6) and 160-161, 166 (from Figure 9) are configured in an OFF state, isolating VIN from VOUT. In addition, the control switches S6, S7, transistors 143, 145 (from Figure 6) and 162-165 (from Figure 9) are configured in an ON state, pre-charging the boost capacitor C_{BOOST}. In addition, the NFET transistor 144 is turned ON or OFF, depending on the input voltage VIN that is applied to the control electrode of the NFET transistor 144. During pre-charge operation, the Cap_top_1 net is pulled to the first supply voltage (VDD1P8) by the control switch S6, the Cap_top_2 net is pulled to the second supply voltage (ground) by the control switch S7, and the p_gate_1 control signal is pulled to the first supply voltage (VDD1P8) by the second circuit branch 162-164 of the control signal generator 9. As a result, the first and second current electrodes of the NFET transistor 144 are pulled to the first supply voltage (VDD1P8). In this pre-charge phase of operation, the following voltages are developed at the indicated nodes: $Cap_top = 1.8 V$ $pos_inj = 0 V$ $Pos_inj_b = 1.8 V$ $pos_inj_b_LS = 3.3 V$ (level shifted pos_inj_b)$cap_top 1 _pu_ 1 _LS = 0 V$ (in pre charge mode, if there is no injection as assumed in this example point) $Cap_top 1 _pu = 0 V$ $Cap_top_ 2 = 0 V$ $CASC = 1.8 V$ $Cap_bot = 0 V$ $SMP = 0 V$ $mux 1 _vg = 0 V$ $p_gate_ 1 = 1.8 V$ $neg_inj = 0 V$ $neg_inj_b = 1.8 V$ $mugvg_pd = 1.8 V$ (if positive injection = 0, as assumed in the example point).

When the SMP signal is asserted as a logic HIGH, the sampling switch circuit enters the tracking (sampling) phase of operation. During the tracking phase, the transistors of the first and second pre-charge circuits S1, S2 and third control switch S3 are turned OFF to isolate the first and second pre-charge circuits and the boost transfer circuit P1, N1 from the first supply voltage (e.g., VDD1P8) and from the second supply voltage (ground), respectively. A voltage stored on boost capacitor C_{BOOST} is coupled to the mux1_vg node which is an analog voltage signal that is based on sum of the first supply voltage VDD1P8 and the VIN voltage signal, and may vary between approximately three times VDD1P8 (VDD1P8*3) and ground voltages. During the tracking phase, the control switches S6-S9, S11, transistors 136-137, 141-142, 144-145 (from Figure 6) and transistors 160-162, 165 (from Figure 9) are configured in an OFF state, connecting VIN to VOUT. In addition, the control switches S4-S5, S10, output switch circuit transistors N10-N13, transistors 138-140, and 166 (from Figure 9) are configured in an ON state. In addition, the PFET transistor 143 and transistors 163-164 are turned ON or OFF, depending on the input voltage VIN. During tracking operation, the Cap_top_1 net is pulled to the combined voltage at the top capacitor plate (VIN + VDD1P8) by the control switch S5. In addition, the Cap_top_2 net is pulled to the combined voltage at the top capacitor plate (VIN + VDD1P8) by the control switch S10. In addition, the p_gate_1 control signal is pulled to the p_gate voltage by the first circuit branch 166 of the control signal generator 9. In this pre-charge phase of operation, the following voltages are developed at the indicated nodes: $Cap_top = 1.8 V + VIN$ $pos_inj = 0 V$ $Pos_inj_b = 1.8 V$ $pos_inj_b_LS = 3.3 V$ (level shifted pos_inj_b) $cap_top 1 _pu_ 1 _LS = 3.3 V$ (level shifted cap_top1_pu1) $Cap _ top 1 _ pu = 1.8 V$ $Cap _ top _ 2 = 1.8 V + VIN$ $CASC = 1.8 V \left(VIN<VDD1P8\right) , VIN \left(VIN>VDD1P8\right)$ $Cap _ bot = VIN$ $SMP = 1.8 V$ $mux 1 _ vg = 1.8 V + VIN$ $p _ gate _ 1 = VIN$ $neg _ inj = 0 V$ $neg _ inj _ b = 1.8 V$ $mugvg _ pd = 0 V .$

When a positive current injection event is detected, the input voltage VIN has exceeded the first reference comparison voltage (e.g., VDD_3P3 = 3.3V), and the current injection detector 7 asserts the positive injection detection signal (pos_inj) as a logic HIGH. In response, the control switches S4-S7, S10-S11, output switch circuit transistors N10-N13, and transistors 138, 145 (from Figure 6) and transitors162-166 (from Figure 9) are configured in an OFF state, isolating VIN from VOUT. In addition, the control switches S8, S9, transistors 136-137, 141, 143, 145, and 160-161 (from Figure 9) are configured in an ON state. As a result of the positive current injection event, the circled transistors 140 and N13 are "at risk" of overvoltage stress since they are each connected directly to the input voltage VIN > VDD_3P3. However, this overvoltage risk is averted by closing the control switch S9 to connect the Cap_top_1 net to the elevated supply voltage (VDD3P3) and opening the control switch S6. In addition, the p_gate_1 control signal is pulled to the elevated supply voltage (VDD3P3) by the first circuit branch 160-161 of the control signal generator 9. In addition, the Cap_top_2 net is pulled to the first supply voltage (VDD1P8) by the control switch S8. In addition, the share source/drain node of transistors 139, 140 and the shared source/drain node of transistors N12, N13 are each pulled to the elevated supply voltage (VDD3P3). As a result, the circled transistors 140 and N13 are protected against overvoltage stress from the input voltage VIN > VDD3P3 by reducing their gate-source voltage. In this positive current injection phase of operation, the following voltages are developed at the indicated nodes: $Cap_top = 1.8 V$ $pos_inj = 1.8 V$ $Pos_inj_b = 0 V$ $pos_inj_b_LS = 1.8 V$ (level shifted pos_inj_b) $cap_top 1 _pu_ 1 _LS = 3.3 V$ (level shifted cap_top1_pu1) $Cap_top 1 _pu = 1.8 V$ $Cap_top_ 2 = 1.8 V$ $CASC = 1.8 V$ $Cap_bot = 0 V$ $SMP = 0 V$ $mux 1 _ vg = 0 V$ $p _ gate _ 1 = 3.3 V$ $neg _ inj = 0 V$ $neg _ inj _ b = 1.8 V$ $mugvg _ pd = 0 V .$

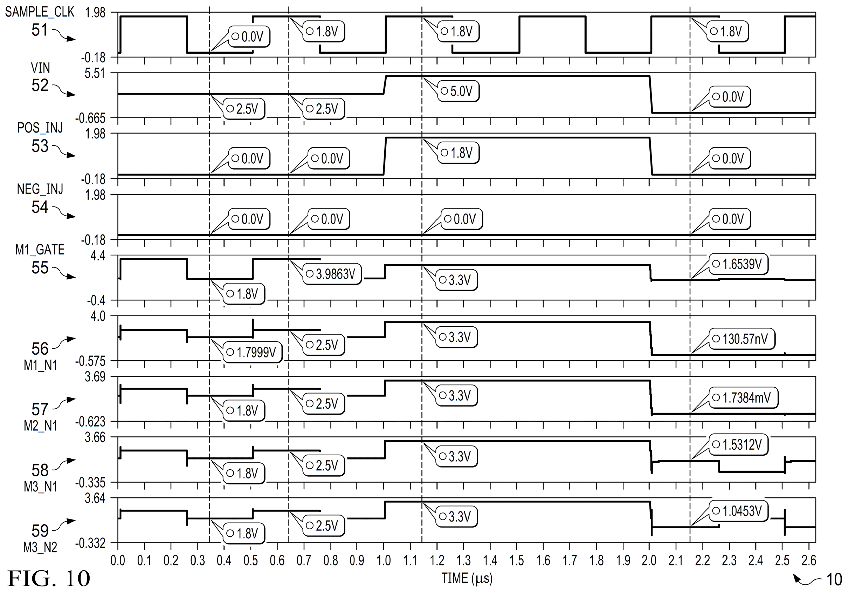

For an improved understanding of selected embodiments of the present disclosure, reference is now made to Figure 10 which shows simulated voltage timing signals 51-59 for voltage nodes seen by devices in the input voltage sampling switch circuit during detected positive injection events. In particular, the SAMPLE_CLK waveform 51 corresponds to the switch control signal SMP provided to the input voltage sampling switch circuit. In addition, the VIN waveform 52 corresponds to the input voltage VIN provided to the input voltage sampling switch circuit. As illustrated, the VIN waveform 52 starts at 2.5V (which does not exceed 2XVDD1P8). At time t=1.0 µs, the VIN waveform 52 rises above twice the voltage supply to 5V to create a positive current injection event. And at time t=2.0 µs, the VIN waveform 52 falls to ground. To indicate the occurrence of a positive current injection event, the depicted POS_INJ waveform 53 is shown at 0V when there is no positive current injection event, and then rises to VDD1P8=1.8V only when there is a positive current injection event. And to indicate the absence of any detected negative current injection event, the depicted NEG_INJ waveform 54 is shown at 0V.

With respect to transistor device N13, the depicted M1_GATE waveform 55 depicts the gate voltage at transistor device N13, the depicted M1_N1 waveform 56 depicts the voltage at the first (drain) current node of transistor device N13, and the depicted VIN waveform 52 depicts the voltage at the second (source) current node of transistor device N13. During normal operation, the depicted waveform 55 for the gate voltage at transistor device N13 (M1) switches between 1.8V and 3.9863V, and the depicted waveforms 56-59 for the source and drain voltages also switch between 1.8V and 2.5V. In particular, the waveform 56 shows the drain voltage for the transistor device N13 (M1_N1), the waveform 57 shows the drain voltage for the transistor device 140 (M2_N1), the waveform 58 shows the drain voltage for the transistor device 144 (M3_N1), and the waveform 59 shows the source voltage for the transistor device 144 (M3_N2). However, during the detected positive current injection event, the gate voltage at transistor device N13 (M1_GATE), the drain voltage for the transistor device N13 (M1_N1), the drain voltage for the transistor device 140 (M2_N1), the drain voltage for the transistor device 144 (M3_N1), and the source voltage for the transistor device 144 (M3_N2) are all clamped at the elevated supply voltage (3.3V), thereby protecting the circled transistor devices N13, 140, 144 from being overstressed by the positive current injection event.

To configure the input voltage sampling switch circuit in precharge in the presence of any type of current injection event, logic circuitry may be included which includes a first NOR gate that is connected to receive the negative injection detection signal (neg_inj) and positive injection detection signal (pos_inj). In the logic circuitry, the output of the first NOR gate is connected to a first input of a first AND gate which is connected to receive an enable signal (EN) at a second input of the first AND gate. In this way, the first AND gate passes the output from the first NOR gate upon reception of the enable signal (EN). In the logic circuitry, the output of the first AND gate is connected to a first input of a second AND gate which is connected to receive a sample clock signal (SMP_CLK) at a second input of the second AND gate. In this way, the second AND gate passes the switch control signal SMP. In the logic circuitry, the switch control signal SMP output from the second AND gate is connected to an inverter which generates the complementary switch control signal SMPB.

In addition, it will be appreciated that the input voltage sampling switch circuit may be configured with a first level shifter module for receiving the complementary positive injection detection signal (pos_inj_b) and generating a level-shifted complementary positive injection detection signal (pos_inj_b_LS). In addition, a second level shifter module may be connected to receive the cap_top1_pu control signal and to generate the level-shifted cap_top1_pu_LS control signal. In addition, a third level shifter module may be connected to receive the cap_top1_pu_1 control signal and to generate the level-shifted cap_top1_pu_1_LS control signal.

When a negative current injection event is detected during the pre-charge phase of operation, the input voltage VIN has gone below the second reference comparison voltage (e.g., VSS = 0V), and the current injection detector 7 asserts the negative injection detection signal (neg_inj) as a logic HIGH. In response, the control switches S5-S6, S8-S10, output switch circuit transistors N10-N13, and transistors 136-137, 139, 143, 145, and 160-161, 166 (from Figure 9) are configured in an OFF state, isolating VIN from VOUT. In addition, the control switches S7, S11, transistors 141-142, and 162-165 (from Figure 9) are configured in an ON state. As a result of the negative current injection event, the circled transistors 140, 144, and N13 are "at risk" of overvoltage stress since they are each connected directly to the input voltage VIN < VSS. However, this overvoltage risk is averted by closing the control switch S11 to connect the Cap_top_1 net to the second supply voltage (VSS) while the control switches S6, S9 are open. In addition, the Cap_top_2 net is pulled to the second supply voltage (ground) by the control switch S7. In addition, the p_gate_1 control signal is pulled to the first supply voltage (VDD1P8) by the second circuit branch 162-165 of the control signal generator 9. In addition, the shared source/drain nodes of the transistors 143-145 are pulled to the second supply voltage (VSS), and the shared source/drain node of the transistors 139-140 is pulled to a threshold voltage below the second supply voltage (VSS - Vth). In addition, the share source/drain node of transistors 138, 139 and the shared source/drain node of transistors N11, N12 are each pulled to the second supply voltage (VSS). In addition, the shared source/drain node of NFET transistors N12, N13 is pulled to the voltage close to the input voltage VIN. As a result, the circled transistors 140, 144, and N13 are protected against overvoltage stress from the input voltage VIN < VSS by reducing their gate-source voltage. In this negative current injection phase of operation, the following voltages are developed at the indicated nodes: $Cap _ top = 1.8 V$ $pos _ inj = 0 V$ $Pos _ inj _ b = 1.8 V$ $pos _ inj _ b _ LS = 3.3 V$ (level shifted pos_inj_b) $cap _ top 1 _ pu _ 1 _ LS = 3.3 V$ (level shifted cap_top1_pu1) $Cap_top 1 _pu = 0 V$ $Cap_top_ 2 = 0 V$ $CASC = 1.8 V$ $Cap_bot = 0 V$ $SMP = 0 V$ $mux 1 _vg = 0 V$ $p_gate_ 1 = 1.8 V$ $neg_inj = 1.8 V$ $neg_inj_b = 0 V$ $mugvg_pd = 1.8 V .$

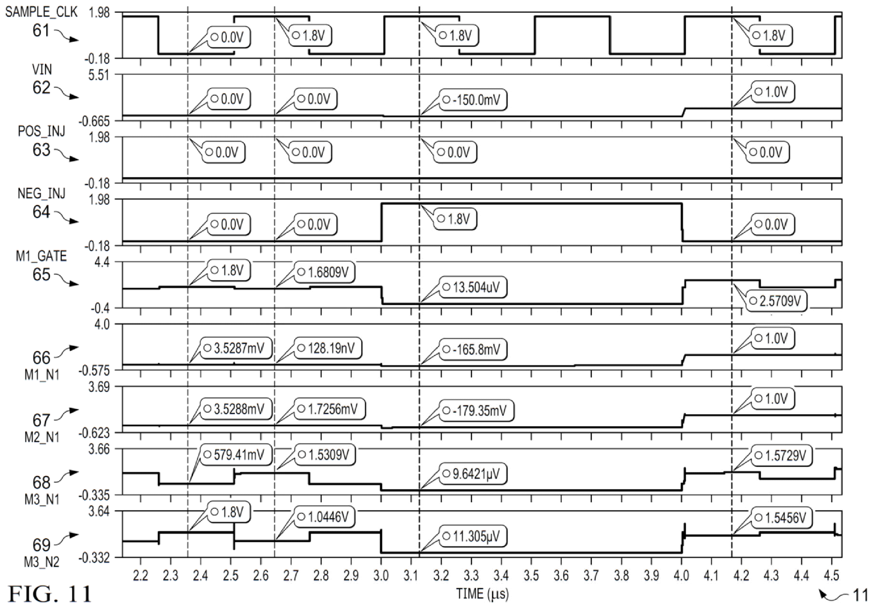

For an improved understanding of selected embodiments of the present disclosure, reference is now made to Figure 11 which shows simulated voltage timing signals 61-69 for voltage nodes seen by devices in the input voltage sampling switch circuit during detected negative injection events. In particular, the SAMPLE_CLK waveform 61 corresponds to the switch control signal SMP provided to the input voltage sampling switch circuit. In addition, the VIN waveform 62 corresponds to the input voltage VIN provided to the input voltage sampling switch circuit. As illustrated, the VIN waveform 62 starts at 0V (ground), and at time t=3.0 µs, the VIN waveform 62 falls below the ground voltage supply to -150 mV to create a negative current injection event. And at time t=4.0 µs, the VIN waveform 62 returns to 0V (ground). To indicate the occurrence of a negative current injection event, the depicted NEG_INJ waveform 64 is shown at 0V when there is no negative current injection event, and then rises to VDD1P8=1.8V only when there is a negative current injection event. And to indicate the absence of any detected positive current injection event, the depicted POS_INJ waveform 63 is shown at 0V.

With respect to transistor device N13, the depicted M1_GATE waveform 65 depicts the gate voltage at transistor device N13, the depicted M1_N1 waveform 66 depicts the voltage at the first (drain) current node of transistor device N13, and the depicted VIN waveform 62 depicts the voltage at the second (source) current node of transistor device N13. During normal operation, the depicted waveform 65 for the gate voltage at transistor device N13 (M1) switches between 1.8V and 1.6809V, and the depicted waveforms 66-69 for the source and drain voltages also switch between the voltage levels as shown. In particular, the waveform 66 shows the drain voltage for the transistor device N13 (M1_N1), the waveform 67 shows the drain voltage for the transistor device 140 (M2_N1), the waveform 68 shows the drain voltage for the transistor device 144 (M3_N1), and the waveform 69 shows the source voltage for the transistor device 144 (M3_N2). However, during the detected negative current injection event, the gate voltage at transistor device N13 (M1) is held to 13.504 µV, the drain voltage for the transistor device N13 (M1_N1) is held to -165.8 mV, the drain voltage for the transistor device 140 (M2_N1) is held to -179.35 mV, the drain voltage for the transistor device 144 (M3_N1) is held to 9.6421 µV, and the source voltage for the transistor device 144 (M3_N2) is held to 11.305 µV, thereby protecting the transistor devices N13, 140, 144 from being overstressed by the negative current injection event.

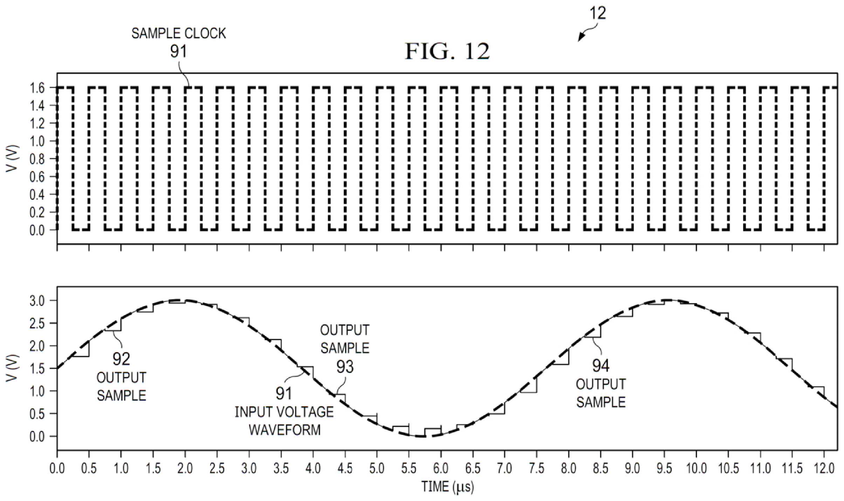

To provide additional details for an improved understanding of selected embodiments of the present disclosure, reference is now made to Figure 12 which depicts various waveforms 12 of an input voltage sampling switch circuit. In particular, the sample clock waveform 91 illustrates an exemplary timing waveform of the switch enable signal SMP which is a digital signal that toggles between a first voltage (e.g., 0 V) and a second voltage (e.g., 1.6 V), and that has a periodic waveform much like a clock signal, for example. The input voltage sampling switch circuit can operate in a pre-charge mode of operation shown when the sample clock waveform 91 has a logic LOW level, and can operate in a sample mode of operation when the sample clock waveform 91 has a logic HIGH level.

In addition, the input voltage (VIN) waveform 91 illustrates exemplary input voltage VIN to the input voltage sampling switch circuit, and the output sampled waveform (e.g., 92, 93, 94) are part of the output voltage VOUT waveform generated by the input voltage sampling switch circuit. In this example, VIN is an analog input voltage signal that varies sinusoidally between 3 V and 0 volts. During the tracking (sampling) mode of operation when the sample clock waveform 91 has a logic HIGH level, the input voltage sampling switch circuit operates in a boost mode to generate the output voltage VOUT waveform samples (e.g., 92-94) by sampling the input voltage VIN. And during the pre-charge mode of operation when the sample clock waveform 91 has a logic LOW level, the boost capacitor is pre-charted to VDD1P8 V and the output voltage VOUT samples (e.g., 92-94) from the input voltage sampling switch circuit are processed by the SAR ADC circuit.

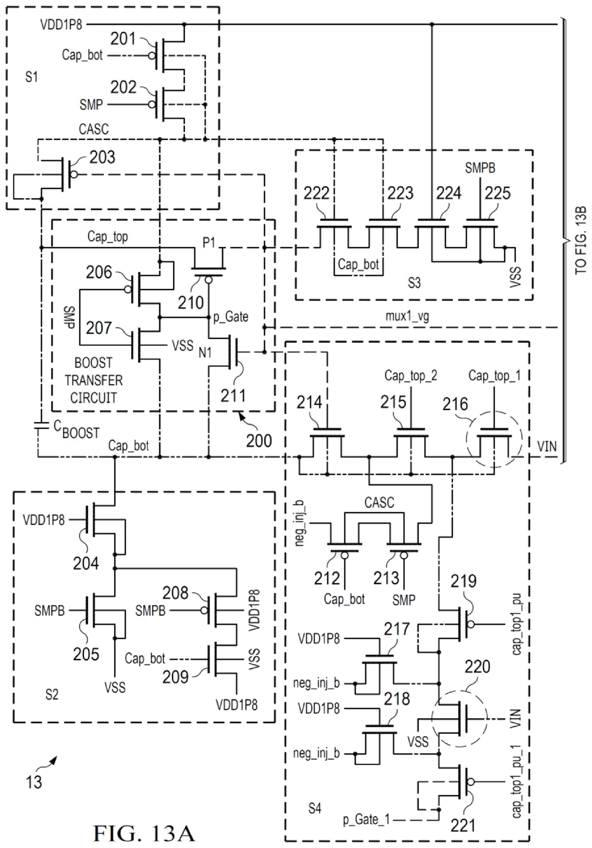

For an improved understanding of selected embodiments of the present disclosure, reference is now made to Figures 13A-C which illustrate a detailed circuit diagram of an input voltage sampling switch circuit which includes a boost capacitor C_{BOOST}, first pre-charge circuit S1 (transistors 201-203), second pre-charge circuit S2 (transistors 204-205, 208-209), a boost transfer circuit 200 (transistors 206-207, 210-211), an output switch circuit (transistors N10-N13) connected between the input voltage VIN and output voltage VOUT, and control switching circuitry S3-S11 which are selective switched to manage the connection of the boost transfer circuit 200 to the output switch circuitry S3-S11 while protecting the gate bias voltages of the "at risk" transistor devices (e.g., N13, 216, 220, 245) that are directly connected to the input voltage VIN during current injection events to protect such transistor devices from being overstressed.

For example and as shown in Figure 13A, the first pre-charge circuit S1 includes a plurality of PFET transistors 201-203 that are connected in series between the first supply voltage (VDD1P8) and the top plate of the boost capacitor C_{BOOST} (Cap_top) as shown. The first PFET transistor 201 has a control electrode connected to receive the voltage from the bottom plate of the boost capacitor C_{BOOST} (Cap_bot). The second PFET transistor 202 has a control electrode connected to receive the switch control signal SMP. The third PFET transistor 203 has a control electrode connected to receive the boosted voltage control signal (mux1_vg) generated by the boost transfer circuit 200. In this way, the PFET transistors 201-203 of the first pre-charge circuit S1 operatively connect the top plate of the boost capacitor C_{BOOST} to the first supply voltage during pre-charge operations, and disconnect the top plate of the boost capacitor C_{BOOST} from the first supply voltage during tracking/sampling operations.

In addition and as shown in Figure 13A, the second pre-charge circuit S2 includes a plurality of NFET transistors 204-205, 208-209 that are connected in series between the bottom plate of the boost capacitor C_{BOOST} (Cap_bot) and either the second supply voltage (VSS) or the first supply voltage (VDD1P8) as shown. The first NFET transistor 204 has a control electrode connected to receive the first supply voltage, a drain current electrode connected to the bottom plate of the boost capacitor C_{BOOST} (Cap_bot), and a source current electrode and body terminal connected to the transistors 215, 208 as shown. The second NFET transistor 205 has a control electrode connected to receive the complementary switch control signal SMPB, a drain current electrode connected to the source current electrode of NFET transistor 204, and a source current electrode and body terminal connected to the second supply voltage as shown. The second pre-charge circuit S2 also includes a first PFET transistor 208 with a control electrode connected to receive the complementary switch control signal SMPB, a source current electrode connected to the source current electrode of NFET transistor 204, a drain current electrode connected to a third NFET transistor 209, and a body terminal connected to the first supply voltage as shown. The third NFET transistor 209 has a control electrode connected to the bottom plate of the boost capacitor C_{BOOST} (Cap_bot), a drain current electrode connected to the drain current electrode of PFET transistor 208, a source current electrode connected to the first supply voltage, and a body terminal connected to the second supply voltage as shown. In this way, the transistors 204-205, 208-209 of the second pre-charge circuit S2 operatively connect the bottom plate of the boost capacitor C_{BOOST} to the second supply voltage during pre-charge operations, and disconnect the bottom plate of the boost capacitor C_{BOOST} from the first supply voltage during tracking/sampling operations.

In addition and as shown in Figure 13A, the boost transfer circuitry 200 includes PFET transistors 206, 210 and NFET transistors 207, 211. A drain current electrode of PFET transistor 210 is connected to a control electrode of NFET transistor 211, a control electrode of PFET transistor 203, a control electrode of NFET transistor 214, a control electrode of NFET transistor N12, and a drain current electrode of transistor 222 at node labeled mux1_vg. A control electrode of PFET transistor 210 is connected to a drain current electrode of PFET transistor 206, a drain current electrode of NFET transistor 207, and a drain current electrode of NFET transistor 211. A control electrode of PFET transistor 206 and a control electrode of NFET transistor 207 are each coupled to receive the SMP signal. A source current electrode and body terminal of PFET transistor 206 are connected to the CASC voltage generated at the shared source/drain node of the PFET transistors 202, 203 in the first pre-charge circuit S1. A drain current electrode of PFET transistor 206 is connected to the drain current electrode of NFET transistor 207. In this embodiment, source current electrodes of transistors 207, 211 are each connected to the bottom plate of the boost capacitor C_{BOOST} (Cap_bot), and the body terminals of the transistors 206, 207 are connected as shown.

In addition and as shown in Figure 13A, the control switch S3 includes a plurality of NFET transistors 222-225 that are connected in series between the second supply voltage and the boosted voltage control signal (mux1_vg). The N-channel transistors 222-225 are configured to form a set of cascoded transistors which are connected and configured to operate in the same way as the output disable circuitry transistors 112-115 described in Figure 3, and therefore no additional description is required.

In addition and as shown in Figure 13A, the control switch S4 includes a plurality of transistors 212-221 which are connected between the input voltage VIN and the bottom plate of the boost capacitor C_{BOOST} (Cap_bot). In addition to receiving the first and second supply voltages, the transistors 212-221 are controlled by the switching control signals mux1_vg, Cap_top_2, Cap_top_1, neg_inj_b, SMP, p_gate_1, Cap_top1_pu_1, cap_top1_pu, and CASC as shown. In particular, the control switch S4 includes a plurality of NFET transistors 214-216 which are source-drain connected between the input voltage VIN and the bottom plate of the boost capacitor C_{BOOST} (Cap_bot), with the control electrode of NFET transistor 214 connected to the boosted voltage control signal (mux1_vg), the control electrode of NFET transistor 215 connected to the Cap_top_2 control signal, and the control electrode of NFET transistor 216 connected to the Cap_top_1 control signal. The common source/drain node of transistors 214, 215 is connected over a pair of PFET transistors 212, 213 to receive the neg_inj_b control signal which is an inverted version of the neg_inj control signal. The PFET transistors 212, 213 have their body terminal connected in common to the CASC control signal, with the control electrode of PFET transistor 212 connected to the SMP control signal and the control electrode of PFET transistor 213 connected to the Cap_bot control signal. In addition, the common source/drain node of transistors 215, 216 is connected over a plurality of transistors 219-221 to receive the p_gate_1 control signal, with the control electrode of PFET transistor 219 connected to the cap_top1_pu control signal, the control electrode of NFET transistor 220 connected to the input voltage VIN, and the control electrode of PFET transistor 221 connected to the cap_top1_pu_1 control signal. As depicted, the body terminal and source current electrode of NFET transistor 219 are connected together, the body terminal of the NFET transistor 220 is connected to the second supply voltage, and the body terminal of the NFET transistor 221 is connected to the p_gate_1 control signal. In addition, the common source/drain node of transistors 219, 220 is connected over an NFET transistor 217 to receive the neg_inj_b control signal, with the control electrode of NFET transistor 217 connected to the first supply voltage VDD1P8 and the body terminal of NFET transistor 217 connected to the neg_inj_b control signal. In addition, the common source/drain node of transistors 220, 221 is connected over an NFET transistor 218 to receive the neg_inj_b control signal, with the control electrode of NFET transistor 218 connected to the first supply voltage VDD1P8 and the body terminal of NFET transistor 218 connected to the neg_inj_b control signal.

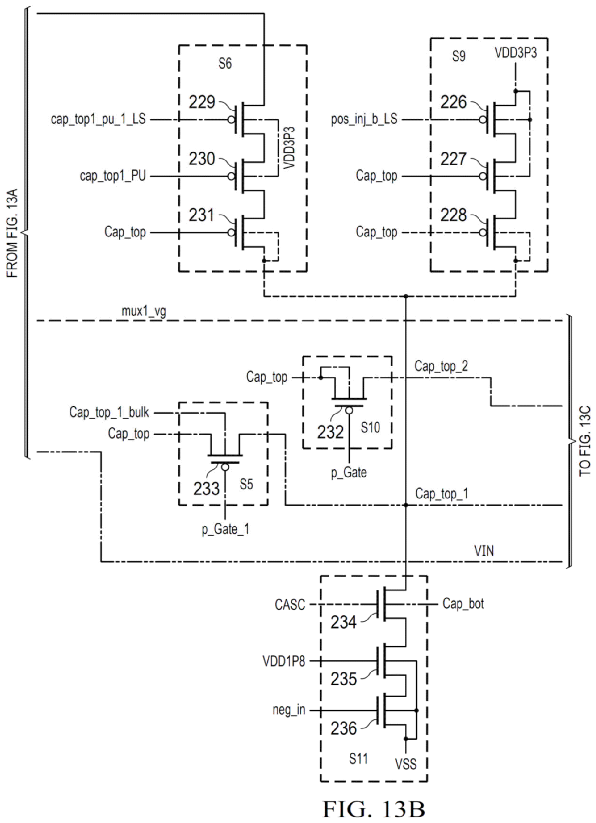

In addition and as shown in Figure 13B, the control switch S5 includes a PFET transistor 233 which connects the top plate of the boost capacitor C_{BOOST} (Cap_top) to the cap_top_1 net (node E) under control of the p_gate_1 control signal which is connected to the control electrode of PFET transistor 233. As depicted, the body terminal of the PFET transistor 233 is connected to the Cap_top_1_bulk control signal. In this configuration, the control switch S5 operatively connects or disconnects the top plate of the boost capacitor C_{BOOST} (Cap_top) and the cap_top_1 net (node E) which is used to control the NFET transistor N13 in the output switch circuit so as to allow the appropriate gate bias voltage to be connected to control the NFET transistor N13.

In addition and as shown in Figure 13B, the control switch S10 includes a PFET transistor 232 which connects the top plate of the boost capacitor C_{BOOST} (Cap_top) to the cap_top_2 net (node D) under control of the p_gate control signal which is connected to the control electrode of PFET transistor 232 in order to provide a bulk connection to prevent forward bias when positive injection occurs. As depicted, the body terminal of the PFET transistor 232 is connected to the Cap_top control signal. In this configuration, the control switch S10 operatively connects or disconnects the top plate of the boost capacitor C_{BOOST} (Cap_top) and the cap_top_2 net (node D) which is used to control the NFET transistor N12 in the output switch circuit so as to allow the appropriate gate bias voltage to be connected to control the NFET transistor N12.

In addition and as shown in Figure 13B, the control switch S6 includes a plurality of PFET transistors 229-231 that are source-drain connected in series between the first supply voltage (VDD1P8) and the cap_top_1 net (node E) as shown. The first PFET transistor 229 has a control electrode connected to receive the Cap_top1_pu_1_LS control signal and has a body terminal connected to the first supply voltage. The second PFET transistor 230 has a control electrode connected to receive the cap_top1_pu control signal and has a body terminal connected to the elevated supply voltage. The third PFET transistor 231 has a control electrode connected to the top plate of the boost capacitor C_{BOOST} (Cap_top) and has a body terminal connected to the cap_top_1 net (node E) as shown. In this way, the PFET transistors 229-231 of the control switch S6 operatively connect the first supply voltage over the cap_top_1 net (node E) as a gate bias voltage for the NFET transistor N13 when there is no current injection event detected and the switch is in the pre-charge state.

In addition and as shown in Figure 13B, the control switch S9 includes a plurality of PFET transistors 226-228 that are source-drain connected in series between an elevated supply voltage (e.g., VDD3P3 = 3.3 V) and the cap_top_1 net (node E) as shown. The first PFET transistor 226 has a control electrode connected to receive the pos_inj_b_LS control signal and has a body terminal connected to the elevated supply voltage. The second PFET transistor 227 has a control electrode connected to the top plate of the boost capacitor C_{BOOST} (Cap_top) and has a body terminal connected to the elevated supply voltage. The third PFET transistor 228 has a control electrode connected to the top plate of the boost capacitor C_{BOOST} (Cap_top) and has a body terminal connected to the cap_top_1 net (node E) as shown. In this way, the PFET transistors 226-228 of the control switch S9 operatively connect the elevated supply voltage over the cap_top_1 net (node E) as a gate bias voltage for the NFET transistor N13 when there is a positive injection event detected.

In addition and as shown in Figure 13B, the control switch S11 includes a plurality of NFET transistors 234-236 that are source-drain connected in series between the cap_top_1 net (node E) and the second supply voltage (VSS) as shown. The first NFET transistor 234 has a control electrode connected to receive the CASC control signal and has a body terminal connected to the bottom plate of the boost capacitor C_{BOOST} (Cap_bot). The second NFET transistor 235 has a control electrode connected to the first supply voltage and has a body terminal connected to the second supply voltage. The third NFET transistor 236 has a control electrode connected to the neg_inj control signal and has a body terminal connected to the second supply voltage as shown. In this way, the NFET transistors 234-236 of the control switch S11 operatively connect the second supply voltage over the cap_top_1 net (node E) as a gate bias voltage for the NFET transistor N13 when there is a negative injection event detected.

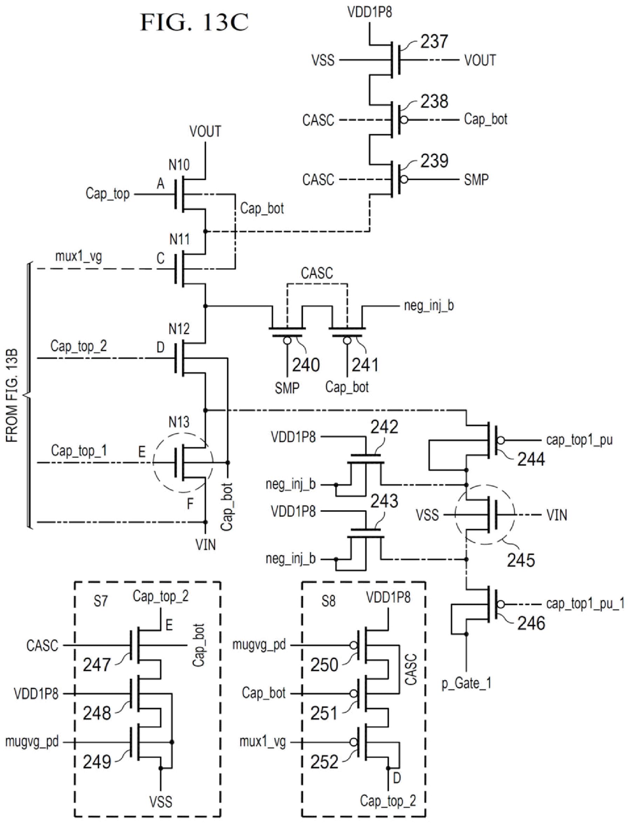

In addition and as shown in Figure 13C, the control switch S7 includes a plurality of NFET transistors 247-249 that are source-drain connected in series between the cap_top_2 net (node D) and the second supply voltage (VSS) as shown. The first NFET transistor 247 has a control electrode connected to receive the CASC control signal and has a body terminal connected to the bottom plate of the boost capacitor CBOOST (Cap_bot). The second NFET transistor 248 has a control electrode connected to the first supply voltage and has a body terminal connected to the second supply voltage. The third NFET transistor 249 has a control electrode connected to the mugvg_pd control signal and has a body terminal connected to the second supply voltage as shown. In this way, the NFET transistors 247-249 of the control switch S7 operatively connect the second supply voltage over the cap_top_2 net (node D) as a gate bias voltage for the NFET transistor N12 when there is no current injection event detected.

In addition and as shown in Figure 13C, the control switch S8 includes a plurality of PFET transistors 250-252 that are source-drain connected in series between the first supply voltage (VDD1P8) and the cap_top_2 net (node D) as shown. The first PFET transistor 250 has a control electrode connected to receive the mugvg_pd control signal and has a body terminal connected to the CASC control signal. The second PFET transistor 251 has a control electrode connected to the bottom plate of the boost capacitor C_{BOOST} (Cap_bot) and has a body terminal connected to the CASC control signal. The third PFET transistor 252 has a control electrode connected to the mux1_vg control signal and has a body terminal connected to the cap_top_2 net (node D) as shown. In this way, the PFET transistors 250-252 of the control switch S8 operatively connect the first supply voltage over the cap_top_2 net (node D) as a gate bias voltage for the NFET transistor N12 when there is a positive current injection event detected.

In addition and as shown in Figure 13C, the output switch circuit includes a plurality of NFET transistors N10-N13 that are source-drain connected in series between the input voltage terminal (VIN) and the output voltage terminal (VOUT) as shown. The first NFET transistor N10 has a control electrode connected to the top plate of the boost capacitor C_{BOOST} (Cap_top) at node A, and has a body terminal connected to the bottom plate of the boost capacitor C_{BOOST} (Cap_bot). The second NFET transistor N11 has a control electrode connected to the mugvg_pd control signal at node C, and has a body terminal connected to the bottom plate of the boost capacitor C_{BOOST} (Cap_bot). The third NFET transistor N12 has a control electrode connected to the cap_top_2 net control signal at node D, and has a body terminal connected to the bottom plate of the boost capacitor C_{BOOST} (Cap_bot). The fourth NFET transistor N13 has a control electrode connected to the cap_top_1 net control signal at node E, and has a body terminal connected to the bottom plate of the boost capacitor C_{BOOST} (Cap_bot) as shown. In this way, the NFET transistors N10-N13 selectively pass the input voltage VIN to the output voltage terminal (VOUT) under control of the gate bias voltages applied to nodes A, C, D, E.

In addition and as shown in Figure 13C, the common source/drain node of transistors N10, N11 is connected over a plurality of transistors 237-239 to the first supply voltage (VDD1P8), with the control electrode of NFET transistor 237 connected to the output voltage VOUT, the control electrode of PFET transistor 238 connected to the bottom plate of the boost capacitor C_{BOOST} (Cap_bot), and the control electrode of PFET transistor 239 connected to the switch control signal SMP. As depicted, the body terminal of NFET transistor 237 is connected to the second supply voltage, the body terminal of the PFET transistor 238 is connected to the CASC control signal, and the body terminal of the PFET transistor 239 is connected to the CASC control signal.

In addition and as shown in Figure 13C, the common source/drain node of transistors N11, N12 is connected over a plurality of PFET transistors 240-241 to the neg_inj_b control signal, with the control electrode of PFET transistor 240 connected to the switch control signal SMP, the control electrode of PFET transistor 241 connected to the bottom plate of the boost capacitor C_{BOOST} (Cap_bot). As depicted, the body terminals of PFET transistors 240-241 are connected to the CASC control signal.

In addition and as shown in Figure 13C, the common source/drain node of transistors N12, N13 is connected over a plurality of transistors 244-246 to receive the p_gate_1 control signal, with the control electrode of PFET transistor 244 connected to the cap_top1_pu control signal, the control electrode of NFET transistor 245 connected to the input voltage VIN, and the control electrode of PFET transistor 246 connected to the cap_top1_pu_1 control signal. As depicted, the body terminal and source current electrode of NFET transistor 244 are connected together, the body terminal of the NFET transistor 245 is connected to the second supply voltage, and the body terminal of the NFET transistor 246 is connected to the p_gate_1 control signal. In addition, the common source/drain node of transistors 244, 245 is connected over an NFET transistor 242 to receive the neg_inj_b control signal, with the control electrode of NFET transistor 242 connected to the first supply voltage VDD1P8 and the body terminal of NFET transistor 242 connected to the neg_inj_b control signal. In addition, the common source/drain node of transistors 245, 246 is connected over an NFET transistor 244 to receive the neg_inj_b control signal, with the control electrode of NFET transistor 243 connected to the first supply voltage VDD1P8 and the body terminal of NFET transistor 243 connected to the neg_inj_b control signal.

As seen from the foregoing, the autoboot strap switching system, apparatus, and methodology are described for handing 2xVDD input voltages with powered current injection protection by providing an injection detector circuit that is designed to identify occurrences of either positive or negative current injection events, and by responding to detected current injection events with control switches which are connected and configured to regulate the gate bias voltages supplied to the output switch FinFET devices to protect the FinFETs during current injection scenarios. By adjusting the gate, source, and drain bias voltages of the output switch FinFET devices, the control switches prevent them from being overstressed. These are like safety switches that kick in when the injection detector circuit senses a problem. Current injection can pose a significant threat to FinFET devices, potentially causing damage or performance degradation. By detecting these events, the injection detector circuit enables protective measures to be activated. For example, if a high voltage source connected to another component on the board starts feeding current into the input of the disclosed autoboot strap switching circuit built with FinFET devices, the injection detector circuit will detect a positive current injection. Similarly, if current flows out of the disclosed autoboot strap switching circuit into another component, the injection detector circuit will detect a negative current injection. In this way, the disclosed autoboot strap switching system, apparatus, and methodology provides several technical advantages, particularly in applications involving mixed-voltage systems. For example, protecting FinFET devices against both positive and negative current injection events significantly enhances the reliability and longevity of the devices, preventing potential damage and ensuring stable operation. This is a major advantage because FinFETs are very sensitive to overvoltage. In addition, the disclosed autoboot strap switching system, apparatus, and methodology promotes compatibility between mixed-voltage systems, thereby facilitating the integration of FinFET devices in systems where other components operate at different voltage levels. This compatibility is crucial in modern electronic designs that often combine different IC technologies on the same board.

A voltage switch for handling over-voltages includes an input terminal for receiving an input voltage that may exceed a voltage rating for at least some transistors in the voltage switch, a current injection detector, a capacitor, pre-charging circuitry for pre-charging the first capacitor, a boost select circuit for generating a boosted voltage from the capacitor, an output switch circuit including an four cascoded FinFET devices which are source-drain connected between the input terminal and an output terminal, and control switches configured to selectively connect, in response to a sampling control signal, a ground supply voltage, intermediate supply voltage, and elevated supply voltage as gate bias voltages to the control electrodes of the plurality of FinFET devices in response to any detected positive current injection event or negative current injection event, thereby preventing overvoltage stress of the first FinFET device.

By now it should be appreciated that there has been provided an input voltage sampling switch method, program code, and system which may be used to sample input voltages significantly higher than the operating supply voltage of the switch while protecting transistors of the switch from receiving voltages beyond an oxide voltage rating of the transistors. The sampling switch circuitry provides a switch resistance that is relatively constant and independent of the input voltage VIN, thereby reducing harmonic distortion and allowing for higher resolution operations. The disclosed input voltage sampling switch includes an input voltage terminal for receiving an input voltage, wherein the input voltage may exceed a voltage rating for at least some transistors in the input voltage sampling switch. In addition, the disclosed input voltage sampling switch includes a current injection detector connected and configured to detect a positive current injection event when an input voltage at the input voltage terminal exceeds an elevated supply voltage and to detect a negative current injection event when the input voltage at the input voltage terminal falls below a ground supply voltage. In selected embodiments, the current injection detector may include a positive injection comparator circuit connected and configured to compare the input voltage to the elevated supply voltage and to generate a positive injection detection signal when the input voltage exceeds the elevated supply voltage, and may also include a negative injection comparator circuit connected and configured to compare the input voltage to the ground supply voltage and to generate a negative injection detection signal when the input voltage falls below the ground supply voltage. The disclosed input voltage sampling switch also includes a first capacitor having a top plate and a bottom plate, with pre-charging circuitry operatively connected to selectively pre-charge the first capacitor to a first voltage by coupling the top plate to a first intermediate supply voltage and the bottom plate to the ground supply voltage in response to a first pre-charge control signal. In selected embodiments, the pre-charging circuitry may include three cascoded transistors which are source-drain connected between the intermediate supply voltage and the top plate of the first capacitor, a first of the three cascoded transistors includes a first current electrode coupled to the intermediate supply voltage and a control electrode connected to the bottom plate of the first capacitor, a second of the three cascoded transistors coupled between the first and third of the three cascoded transistors includes a control electrode connected to receive a switch control signal, and a third of the three cascoded transistors includes a first current electrode coupled to the top plate of the first capacitor. In addition, the disclosed input voltage sampling switch includes a boost select circuit operatively connected to the first capacitor to generate a boosted voltage from the first voltage. In selected embodiments, the boost select circuit may include first transistor and second transistors, the first transistor having a first current electrode coupled to the top plate of the first capacitor and a second current electrode coupled to a boost node for generating the boost voltage, and second transistor having a first current electrode coupled to a control electrode of the first transistor, a control electrode coupled to the boost node, and a second current electrode coupled to the bottom plate of the first capacitor. The disclosed input voltage sampling switch also includes an output switch circuit having a plurality of FinFET devices which are source-drain connected between the input voltage terminal and an output voltage terminal, wherein a first FinFET device has a first current electrode connected to the input voltage terminal, wherein a second FinFET device has a current electrode connected to the output voltage terminal, and wherein each FinFET device has a separate control electrode and first and second current electrodes. In addition, the disclosed input voltage sampling switch includes a plurality of control switches operatively connecting the boost select circuit and first capacitor to the output switch circuit and configured to selectively connect, in response to a second sampling control signal, the ground supply voltage, intermediate supply voltage, and elevated supply voltage as gate bias voltages to the control electrodes of the plurality of FinFET devices in response to any detected positive current injection event or negative current injection event, thereby preventing overvoltage stress of the first FinFET device. In selected embodiments, the plurality of control switches may include a first control switch for connecting a control electrode of the first FinFET device to the ground supply voltage during a sampling phase of operation in response to the current injection detector detecting a negative current injection event. In other selected embodiments, the plurality of control switches may include a first control switch for connecting a control electrode of the first FinFET device to the elevated supply voltage during a sampling phase of operation in response to the current injection detector detecting a positive current injection event. In such embodiments, the plurality of control switches may include a second control switch for connecting the intermediate supply voltage to a control electrode of a second FinFET device that is source-drain connected to the first FinFET device during a sampling phase of operation in response to the current injection detector detecting a positive current injection event. In other selected embodiments, the plurality of control switches may include a first control switch for connecting a control electrode of the first FinFET device to the intermediate supply voltage during a sampling phase of operation in response to the current injection detector not detecting a positive current injection event or negative current injection event. In selected embodiments, the output voltage terminal is coupled to an input terminal of an analog-to-digital converter. In other selected embodiments, the ground supply voltage is approximately 0 volts, the intermediate supply voltage is approximately 1.8 volts, and the elevated supply voltage is approximately 3.3 volts.

In another form, there has been provided a voltage sampling circuit method, program code, and system which may be used to sample input voltages significantly higher than the operating supply voltage of the voltage sampling circuit while protecting transistors of the voltage sampling circuit from receiving voltages beyond an oxide voltage rating of the transistors. The disclosed voltage sampling circuit includes an input voltage terminal for receiving an input voltage, wherein the input voltage may exceed a voltage rating for at least some transistors in the voltage sampling circuit. In addition, the disclosed voltage sampling circuit includes a current injection detector connected and configured to detect a positive current injection event when an input voltage at the input voltage terminal exceeds an elevated supply voltage and to detect a negative current injection event when the input voltage at the input voltage terminal falls below a ground supply voltage. In selected embodiments, the current injection detector may include a positive injection comparator circuit connected and configured to generate a positive injection detection signal when the input voltage exceeds the elevated supply voltage, and may also include a negative injection comparator circuit connected and configured to generate a negative injection detection signal when the input voltage falls below the ground supply voltage. The disclosed input voltage sampling switch also includes a first capacitor having a first capacitor terminal and a second capacitor terminal. In addition, the disclosed voltage sampling circuit includes a first pre-charge circuit coupled between a first supply voltage and to the first capacitor terminal, the first pre-charge circuit configured to receive a first sampling control signal and pre-charge the first capacitor to a first voltage. The disclosed input voltage sampling switch also includes a boost select circuit having a first input coupled to the first capacitor terminal and an output coupled to a boost node. In addition, the disclosed voltage sampling circuit includes an output switch circuit which includes four cascoded transistors which are source-drain connected between the input voltage terminal and the output voltage terminal, with a first control electrode of a first of the cascoded transistors connected to the first capacitor terminal, with a second control electrode of a second of the cascoded transistors connected to the boost node, and with third and fourth control electrodes of third and fourth of the cascoded transistors operatively connected over a plurality of control switches to selectively connect, in response to a second sampling control signal, the ground supply voltage, the first supply voltage, and an elevated supply voltage as gate bias voltages to the third and fourth control electrodes of the third and fourth cascoded transistors in response to any detected positive current injection event or negative current injection event, thereby preventing overvoltage stress of the fourth of the cascoded transistors. In selected embodiments, the four cascoded transistors may include four n-type FinFET devices, including a first n-type FinFET device where the first control electrode controls current flow between first and second current electrodes of the first n-type FinFET device, where the first current electrode is coupled to the output voltage terminal. In addition, the four n-type FinFET devices may include a second n-type FinFET device where the second control electrode controls current flow between first and second current electrodes of the second n-type FinFET device, where the first current electrode of the second n-type FinFET device is coupled to the second current electrode of the first n-type FinFET device. In addition, the four n-type FinFET devices may include a third n-type FinFET device where the third control electrode controls current flow between first and second current electrodes of the third n-type FinFET device, where the first current electrode of the third n-type FinFET device is coupled to the second current electrode of the second n-type FinFET device. In addition, the four n-type FinFET devices may include a fourth n-type FinFET device where the fourth control electrode controls current flow between first and second current electrodes of the fourth n-type FinFET device, where the first current electrode of the fourth n-type FinFET device is coupled to the second current electrode of the third n-type FinFET device and where the second current electrode of the fourth n-type FinFET device is coupled to the input voltage terminal. In selected embodiments, the plurality of control switches may include a first control switch for connecting a control electrode of the fourth cascoded transistor to the ground supply voltage during a sampling phase of operation in response to the current injection detector detecting a negative current injection event. In other selected embodiments, the plurality of control switches may include a first control switch for connecting a control electrode of the fourth cascoded transistor to the elevated supply voltage during a sampling phase of operation in response to the current injection detector detecting a positive current injection event. In such embodiments, the plurality of control switches may include a second control switch for connecting the first supply voltage to a control electrode of a third cascoded transistor device that is source-drain connected to the fourth cascoded transistor during a sampling phase of operation in response to the current injection detector detecting a positive current injection event. In other selected embodiments, the plurality of control switches may include a first control switch for connecting a control electrode of the fourth cascoded transistor to the first supply voltage during a sampling phase of operation in response to the current injection detector not detecting a positive current injection event or negative current injection event. In selected embodiments, the output voltage terminal is coupled to an input terminal of an analog-to-digital converter. In other selected embodiments, the ground supply voltage is approximately 0 volts, the first supply voltage is approximately 1.8 volts, and the elevated supply voltage is approximately 3.3 volts.

In yet another form, there is provided a voltage sampling method, circuit and system. The disclosed method includes providing an input voltage to a voltage sampling circuit having an input voltage terminal connected over an output voltage switch to an output voltage terminal, wherein the input voltage is higher than a gate oxide voltage rating for transistors in the voltage sampling circuit, and wherein the output voltage switch includes four cascoded transistors connected in series between the input voltage terminal and the output voltage terminal. The four cascoded transistors include a first transistor having a first current electrode coupled to the output voltage terminal, a control electrode coupled to a first plate of a capacitor, and a second current electrode. The four cascoded transistors also include a second transistor having a first current electrode coupled to the second current electrode of the first transistor, a control electrode coupled to a boost node, and a second current electrode. In addition, the four cascoded transistors include a third transistor having a first current electrode coupled to the second current electrode of the second transistor, a control electrode, and a second current electrode. The four cascoded transistors also include a fourth transistor having a first current electrode coupled to the second current electrode of the third transistor, a control electrode, and a second current electrode coupled to the input voltage terminal. In addition, the disclosed method includes detecting a current injection event when the input voltage at the input voltage terminal exceeds or falls below a threshold supply voltage. When an enable signal is not asserted, the disclosed method includes pre-charging the capacitor to an intermediate supply voltage within the gate oxide voltage rating for transistors in the voltage sampling circuit and disabling an output voltage switch connected between the boost node and a ground supply voltage. And when the enable signal is asserted, the disclosed method includes using the capacitor to boost a voltage at the boost node to a level above the input voltage while using a plurality of control switches to selectively connect the ground supply voltage, the intermediate supply voltage, and an elevated supply voltage as gate bias voltages to the control electrodes of the third and fourth transistors of the four cascoded transistors in response to any detected current injection event to prevent overvoltage stress of the fourth transistor.

Each signal described herein may be designed as positive or negative logic, where negative logic can be indicated by a bar over the signal name or an asterisk (*) or letter "b" following the name. In the case of a negative logic signal, the signal is active low where the logically true state corresponds to a logic level zero. In the case of a positive logic signal, the signal is active high where the logically true state corresponds to a logic level one. Note that any of the signals described herein can be designed as either negative or positive logic signals. Therefore, in alternate embodiments, those signals described as positive logic signals may be implemented as negative logic signals, and those signals described as negative logic signals may be implemented as positive logic signals.

Because the apparatus described in the present disclosure is, for the most part, composed of electronic components and circuits known to those skilled in the art, circuit details will not be explained in any greater extent than that considered necessary as illustrated above, for the understanding and appreciation of the underlying concepts of the present disclosure and in order not to obfuscate or distract from the teachings of the present disclosure.

Although the present disclosure has been described with respect to specific conductivity types or polarity of potentials, skilled artisans appreciated that conductivity types and polarities of potentials may be reversed.

Architectures depicted herein are merely exemplary, and it will be appreciated that other architectures can be implemented which achieve the same functionality. In an abstract, but still definite sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected," or "operably coupled," to each other to achieve the desired functionality. As used herein, the term "coupled" when referring to circuit or system components is used to describe an appropriate, wired or wireless, direct or indirect, connection between one or more components through which information or signals can be passed from one component to another. Furthermore, the term "coupled" when used in reference to electric circuit components or electric circuits generally encompasses both direct and indirect connections unless otherwise stated.

Furthermore, those skilled in the art will recognize that boundaries between the functionality of the above-described operations are merely illustrative. The functionality of multiple operations may be combined into a single operation, and/or the functionality of a single operation may be distributed in additional operations. Moreover, alternative embodiments may include multiple instances of a particular operation, and the order of operations may be altered in various other embodiments.

Although the present disclosure is described herein with reference to specific embodiments, various modifications and changes can be made without departing from the scope of the present disclosure as set forth in the claims below. Accordingly, the specification and figures are to be regarded in an illustrative rather than a restrictive sense, and all such modifications are intended to be included within the scope of the present disclosure. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

Various illustrative embodiments of the present invention have been described in detail with reference to the accompanying figures. While various details are set forth in the foregoing description, it will be appreciated that the present invention may be practiced without these specific details, and that numerous implementation-specific decisions may be made to the invention described herein to achieve the circuit designer's specific goals, such as compliance with process technology or design-related constraints, which will vary from one implementation to another. While such a development effort might be complex and time-consuming, it would nevertheless be a routine undertaking for those of ordinary skill in the art having the benefit of this disclosure. For example, selected aspects are shown in block diagram form, rather than in detail, in order to avoid limiting or obscuring the present invention. In addition, some portions of the detailed descriptions provided herein are presented in terms of algorithms or operations on data within a computer memory. Such descriptions and representations are used by those skilled in the art to describe and convey the substance of their work to others skilled in the art. Although the described exemplary embodiments disclosed herein are directed to an exemplary input voltage sampling switch used with an SAR ADC, the present disclosure is not necessarily limited to the example embodiments illustrate herein, and various embodiments of the circuitry and methods disclosed herein may be implemented with other devices and software components. Thus, the particular embodiments disclosed above are illustrative only and should not be taken as limitations upon the present invention, as the invention may be modified and practiced in different but equivalent manners apparent to those skilled in the art having the benefit of the teachings herein. Accordingly, the foregoing description is not intended to limit the invention to the particular form set forth, but on the contrary, is intended to cover such alternatives, modifications and equivalents as may be included within the spirit and scope of the invention as defined by the appended claims so that those skilled in the art should understand that they can make various changes, substitutions and alterations without departing from the spirit and scope of the invention in its broadest form.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. An input voltage sampling switch, comprising:
an input voltage terminal for receiving an input voltage, wherein the input voltage may exceed a voltage rating for at least some transistors in the input voltage sampling switch;
a current injection detector configured to detect a positive current injection event when an input voltage at the input voltage terminal exceeds an elevated supply voltage and to detect a negative current injection event when the input voltage at the input voltage terminal falls below a ground supply voltage;
first capacitor including a top plate and a bottom plate;
pre-charging circuitry configured to selectively pre-charge the first capacitor to a first voltage by coupling the top plate to a first intermediate supply voltage and the bottom plate to the ground supply voltage in response to a first pre-charge control signal;
a boost select circuit coupled to the first capacitor to generate a boosted voltage from the first voltage;
an output switch circuit comprising a plurality of FinFET devices which are source-drain connected between the input voltage terminal and an output voltage terminal, wherein a first FinFET device has a first current electrode connected to the input voltage terminal, wherein a second FinFET device has a current electrode connected to the output voltage terminal, and wherein each FinFET device has a separate control electrode and first and second current electrodes; and
a plurality of control switches coupling the boost select circuit and first capacitor to the output switch circuit and configured to selectively connect, in response to a second sampling control signal, the ground supply voltage, intermediate supply voltage, and elevated supply voltage as gate bias voltages to the control electrodes of the plurality of FinFET devices in response to any detected positive current injection event or negative current injection event, thereby preventing overvoltage stress of the first FinFET device.

2. The input voltage sampling switch of claim 1, where the current injection detector comprises:
a positive injection comparator circuit configured to compare the input voltage to the elevated supply voltage and to generate a positive injection detection signal when the input voltage exceeds the elevated supply voltage; and
a negative injection comparator circuit configured to compare the input voltage to the ground supply voltage and to generate a negative injection detection signal when the input voltage falls below the ground supply voltage.

3. The input voltage sampling switch of claim 1 or 2, where the pre-charging circuitry comprises three cascoded transistors which are source-drain connected between the intermediate supply voltage and the top plate of the first capacitor, a first of the three cascoded transistors includes a first current electrode coupled to the intermediate supply voltage and a control electrode connected to the bottom plate of the first capacitor, a second of the three cascoded transistors coupled between the first and third of the three cascoded transistors includes a control electrode connected to receive a switch control signal, and a third of the three cascoded transistors includes a first current electrode coupled to the top plate of the first capacitor.

4. The input voltage sampling switch of any preceding claim, where boost select circuit comprises:
a first transistor having a first current electrode coupled to the top plate of the first capacitor and a second current electrode coupled to a boost node for generating the boost voltage; and
a second transistor having a first current electrode coupled to a control electrode of the first transistor, a control electrode coupled to the boost node, and a second current electrode coupled to the bottom plate of the first capacitor.

5. The input voltage sampling switch of any preceding claim, where the plurality of control switches comprises a first control switch for connecting a control electrode of the first FinFET device to the ground supply voltage during a sampling phase of operation in response to the current injection detector detecting a negative current injection event.

6. The input voltage sampling switch of any preceding claim, where the plurality of control switches comprises a first control switch for connecting a control electrode of the first FinFET device to the elevated supply voltage during a sampling phase of operation in response to the current injection detector detecting a positive current injection event.

7. The input voltage sampling switch of claim 6, where the plurality of control switches comprises a second control switch for connecting the intermediate supply voltage to a control electrode of a second FinFET device that is source-drain connected to the first FinFET device during a sampling phase of operation in response to the current injection detector detecting a positive current injection event.

8. The input voltage sampling switch of any preceding claim, where the plurality of control switches comprises a first control switch for connecting a control electrode of the first FinFET device to the intermediate supply voltage during a sampling phase of operation in response to the current injection detector not detecting a positive current injection event or negative current injection event.

9. The input voltage sampling switch of any preceding claim, wherein the output voltage terminal is coupled to an input terminal of an analog-to-digital converter.

10. The input voltage sampling switch of any preceding claim, wherein the ground supply voltage is approximately 0 volts, the intermediate supply voltage is approximately 1.8 volts, and the elevated supply voltage is approximately 3.3 volts.

11. A method comprising:
providing an input voltage to a voltage sampling circuit comprising an input voltage terminal coupled over an output voltage switch to an output voltage terminal, wherein the input voltage is higher than a gate oxide voltage rating for transistors in the voltage sampling circuit, and wherein the output voltage switch comprises four cascoded transistors connected in series between the input voltage terminal and the output voltage terminal,
a first transistor of the four cascoded transistors including a first current electrode coupled to the output voltage terminal, a control electrode coupled to a first plate of a capacitor, and a second current electrode,
a second transistor of the four cascoded transistors including a first current electrode coupled to the second current electrode of the first transistor, a control electrode coupled to a boost node, and a second current electrode,
a third transistor of the four cascoded transistors including a first current electrode coupled to the second current electrode of the second transistor, a control electrode, and a second current electrode, and
a fourth transistor of the four cascoded transistors including a first current electrode coupled to the second current electrode of the third transistor, a control electrode, and a second current electrode coupled to the input voltage terminal;
detecting a current injection event when the input voltage at the input voltage terminal exceeds or falls below a threshold supply voltage;
when an enable signal is not asserted, pre-charging the capacitor to an intermediate supply voltage within the gate oxide voltage rating for transistors in the voltage sampling circuit and disabling an output voltage switch connected between the boost node and a ground supply voltage; and
when the enable signal is asserted, using the capacitor to boost a voltage at the boost node to a level above the input voltage while using a plurality of control switches to selectively connect the ground supply voltage, the intermediate supply voltage, and an elevated supply voltage as gate bias voltages to the control electrodes of the third and fourth transistors of the four cascoded transistors in response to any detected current injection event to prevent overvoltage stress of the fourth transistor.
